(19) Europäisches Patentamt
European Patent Office
Office européen des brevets

(11) **EP 1 223 235 A1**

(12) **EUROPEAN PATENT APPLICATION**
published in accordance with Art. 158(3) EPC

(43) Date of publication:
**17.07.2002 Bulletin 2002/29**

(51) Int Cl.⁷: **C30B 29/54**

(21) Application number: **00935654.4**

(22) Date of filing: **12.06.2000**

(86) International application number:
**PCT/JP00/03820**

(87) International publication number:
**WO 00/77280 (21.12.2000 Gazette 2000/51)**

(84) Designated Contracting States:
**AT BE CH CY DE DK ES FI FR GB GR IE IT LI LU MC NL PT SE**

(30) Priority: **14.06.1999 JP 16710999**
**17.06.1999 JP 17079699**
**04.01.2000 JP 2000000049**
**31.01.2000 JP 2000022640**

(71) Applicant: **SUMITOMO METAL INDUSTRIES, LTD.**
**Osaka-shi, Osaka 541-0041 (JP)**

(72) Inventors:
• **AKIOKA, Koji**
**Amagasaki-shi, Hyogo 660-0891 (JP)**
• **SANJOH, Akira**
**Nara-shi, Nara 631-0006 (JP)**

(74) Representative: **Stuart, Ian Alexander et al**
**MEWBURN ELLIS**
**York House**
**23 Kingsway**
**London WC2B 6HP (GB)**

(54) **APPARATUS AND METHOD FOR SEPARATING ORGANIC MOLECULES AND METHOD FOR FORMING CRYSTAL OF ORGANIC MOLECULES**

(57)    An apparatus and a method useful for crystallization of a biopolymer such as protein are provided. A crystal growth apparatus (10) has a solid surface (11a) consisting of a silicon oxide and a solid surface (12a) consisting of alumina. In this apparatus (10), the solid surface (11a) and the solid surface (12a) are arranged to simultaneously come into contact with a solution (14) containing protein (13) to be crystallized. The solid surface (11a) and the solid surface (12a) have surface potentials or zeta potentials different from each other when coming into contact with the solution (14). For example, the solid surface (11a) is negatively charged, and the solid surface (12a) is positively charged. Therefore, the protein (13) negatively charged in the solution (14) is selectively adsorbed to the positively charged solid surface (12a). Thus, a crystal of the protein (13) grows on the solid surface (12a).

FIG.3

## Description

Technical Field

The present invention relates to an apparatus for and a method of separating substances such as organic molecules charged in a solution, and more particularly, it relates to a separation apparatus and a separation method applied to crystallization of organic polymers including various biopolymers such as protein, enzyme etc. and complexes thereof. Further, the present invention relates to an apparatus and a method for preparing a crystal of a polymer and a kit for the apparatus, and more particularly, it relates to an apparatus, a method and a kit applied to crystallization of polymers including various biopolymers such as protein, enzyme etc. and complexes thereof.

Background Art

Crystallization of a biopolymer such as protein is basically performed by eliminating a solvent from water or a nonaqueous solution containing the polymer for supersaturating the biopolymer and growing a crystal, similarly to the case of a general low molecular weight compound such as inorganic salt. Typical methods for such crystallization include a batch method, dialysis and vapor diffusion, which are selectively used in response to the type, quantity, property etc. of a sample.

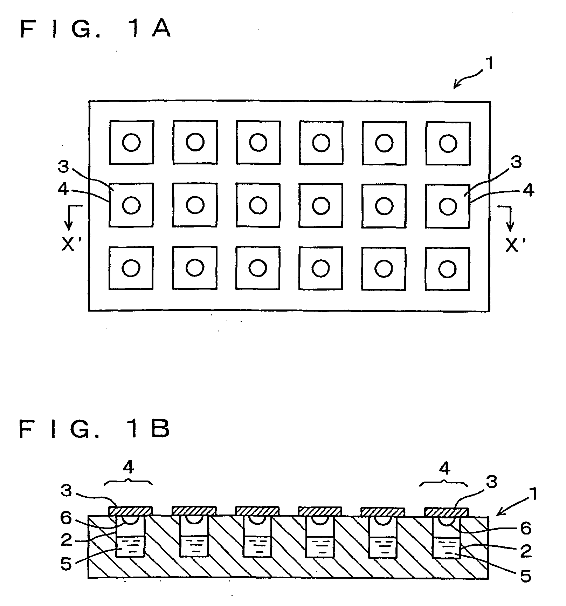

Figs. 1A and 1B show an apparatus 1 for trying crystallization by vapor deposition under various conditions. The apparatus 1 has a number of wells 2, so that each well 2 and each plate 3 form a cell 4 for crystallization. Each well 2 holds a precipitant 5, while a mother liquor 6 containing a biopolymer to be crystallized is dropped onto each plate 3 blocking an opening of the well 2. In this apparatus 1, equilibrium is set up due to evaporation of volatile components contained in the precipitant 5 and the mother liquor 6.

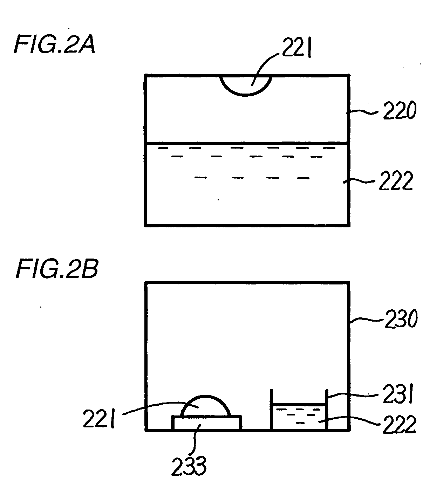

Figs. 2A and 2B schematically show a hanging-drop method and a sitting-drop method included in vapor diffusion respectively. In the hanging-drop method shown in Fig. 2A, a mother liquor 221 containing a biopolymer to be crystallized is dropped in a closed vessel 220 storing a precipitant 222. In the sitting-drop method shown in Fig. 2B, a mother liquor 221 containing a biopolymer to be crystallized is placed on a plate 233 in a closed vessel 230. A precipitant 222 is stored in another vessel 231 in the closed vessel 230. According to these methods, equilibrium is loosely set up due to evaporation of volatile components contained in the precipitants and the mother liquors.

In order to decide the three-dimensional structure of a biopolymer by X-ray crystallographic analysis, the target substance must be extracted, purified and thereafter crystallized. According to a conventional method, the operator progresses crystallization while repeating trial and error based on his intuition and experience. In this case, research must be made under an extremely large number of experimental conditions for obtaining a crystal of the biopolymer, and crystal growth is regarded as the largest bottleneck in the field of X-ray crystallographic analysis.

As a new method substituting for the conventional method or a method for more efficiently growing a crystal in combination with the conventional method, a method of and an apparatus for performing crystallization with a semiconductor substrate having controlled valence electrons or the like (refer to International Patent Laying-Open Nos. WO96/26781, WO97/49845, WO98/02601 and WO99/23284). According to this method, a crystal nucleus can be fixed to the surface of a solid-state component brought into a prescribed electric state by valence control due to electrostatic action. A compound such as protein flocculates on the surface of the solid-state component due to electrostatic interaction so that formation of a crystal nucleus can be prompted for bringing growth of a crystal. Crystallization can be controlled by controlling electric characteristics on the surface of the solid-state component.

A crystal of a biopolymer generally contains a large quantity ($\geqq$ 50 volume %, for example) of solvent, dissimilarly to other substances. When such a crystal is left in the air, the solvent is scattered to break the crystal. In order to prevent this, the crystal is generally sealed in a glass capillary along with a mother liquor, and subjected to an X-ray crystallographic analysis experiment under the atmosphere of the mother liquor having concentration and pH at equilibrium. Recently, a technique, referred to as flash cooling, of instantaneously freezing a biopolymer crystal with liquid nitrogen or the like may be employed for performing X-ray crystallographic analysis while keeping a solvent contained in the crystal in a glass state. Anyway, it is important to grow a crystal of a sufficient size from a mother liquor, to be subjected to X-ray crystallographic analysis with no breakage.

Disclosure of the Invention

An object of the present invention is to technically solve problems of a conventional crystallization process progressed while repeating trial and error.

Another object of the present invention is to provide an apparatus and a method capable of flocculating and adsorbing a biopolymer contained in a solution to a specific region of a solid surface with electrostatic action.

More specifically, the object of the present invention is to provide a technique of reducing influence by convection in a solution influenced by gravity and controlling nucleation in crystallization of various biopolymers and a vital tissue mainly formed by biopolymers.

Still another object of the present invention is to provide a technique capable of obtaining a large-sized crystal capable of enabling X-ray crystallographic analysis by suppressing or controlling mass generation of microcrystals.

A further object of the present invention is to provide a technique for enabling crystallization with a small quantity of biopolymer solution.

A further object of the present invention is to provide a method of and an apparatus for enabling crystallization with a small quantity of solution.

A further object of the present invention is to provide an apparatus and a method capable of readily taking out a generated crystal without breaking the same.

A further object of the present invention is to technically solve problems in a process of taking out a crystal in a technique of growing a crystal of a biopolymer such as protein on a solid surface.

A further object of the present invention is to provide a technique capable of readily finding conditions suitable for crystallization.

In particular, a further object of the present invention is to provide a novel screening apparatus and a novel screening method capable of bringing conditions suitable for crystallization or flocculation of various polymers in a shorter time.

According to an aspect of the present invention, an apparatus for separating a charged substance contained in a solution from the solution comprises a plurality of types of solids consisting of materials substantially different from each other selected from a group consisting of a metal, a semiconductor and a compound thereof. In this apparatus, the surfaces of the plurality of types of solids are arranged to simultaneously come into contact with the solution, and the surfaces of the plurality of types of solids have surface potentials or zeta potentials different from each other when coming into contact with the solution, thereby more strongly electrostatically adsorbing the substance to the surface of any of the plurality of types of solids.

In the apparatus according to the present invention, at least one of the plurality of types of solids may have a porous surface. The surface of the solid having the porous surface can have a surface potential or a zeta potential different from those of the surfaces of the remaining solids, so that the substance can be more strongly electrostatically adsorbed to the porous surface. Preferably, the porous surface mainly has pores having a pore diameter substantially equivalent to or not more than the size of the substance to be separated. Preferably, the material for the solid having the porous surface is alumina.

The apparatus according to the present invention preferably further comprises an enclosure wall for holding the solution on the surfaces of the plurality of types of solids.

In a preferred mode of the present invention, the plurality of types of solids are arranged to be adjacent to each other in a prescribed region, and the area occupied by the surface of the solid more strongly electrostatically adsorbing the substance is not more than the area occupied by the surfaces of the remaining solids in the prescribed region.

In the apparatus according to the present invention, the plurality of types of solids can be formed on the same substrate. The substrate can be a semiconductor substrate.

In the apparatus according to the present invention, the materials providing the plurality of types of solids can have a multilayer structure, and the upper layer material can be provided on a plurality of positions on the lower layer material at intervals.

According to another aspect of the present invention, an apparatus for separating a charged substance contained in a solution from the solution has a surface for coming into contact with the solution, the surface has a plurality of regions, the respective ones of the plurality of regions are surfaces exposing materials substantially different from each other selected from a group consisting of a metal, a semiconductor and a compound thereof, the plurality of regions are charged to surface potentials different from each other when coming into contact with the solution, and one of plurality of regions electrostatically adsorbs the charged substance more strongly than the others of the plurality of regions.

According to still another aspect of the present invention, an apparatus for separating a charged substance contained in a solution from the solution comprises a first solid and a second solid, wherein the first solid is a semiconductor substrate and the second solid is an island made of a semiconductor compound or an island made of a metal compound formed on the first solid. The surface of the first solid and the surface of the second solid are charged to surface potentials or zeta potentials different from each other when coming into contact with the solution, thereby the surface of the second solid electrostatically adsorbs the charged substance more strongly. Preferably, the semiconductor substrate is a silicon substrate. The material for at least the top portion of the island can be any of a silicon oxide, a silicon nitride, a metal oxide and a metal nitride. The width of the top portion of the island is preferably 10 $\mu$m to 200 $\mu$m. The apparatus can have an enclosure wall for holding the solution, provided on the surface of the first solid to enclose the island. Preferably, the first solid and the second solid are arranged to be adjacent to each other in a region enclosed with the enclosure wall, and the area of the surface of the top portion of the second solid is smaller than the area of the surface of the first solid in this region. The second solid can be a plurality of islands having different widths of top portions. For example, the combination of the material for the surface part of the first solid and the material for the surface part of the second solid is a combination of any of silicon and a silicon oxide, silicon and a silicon nitride, and silicon and alumina.

According to a further aspect of the present invention, an apparatus for separating a charged substance contained in a solution from the solution comprises a semiconductor substrate, a first solid and a second solid, the first solid is a semiconductor compound film or a metal compound film formed on the semiconductor substrate, and the second solid is an island made of a semiconductor compound or an island made of a metal compound formed on the first solid. The surface of the first solid and the surface of the second solid are charged to surface potentials or zeta potentials different from each other when coming into contact with the solution, thereby the surface of the second solid electrostatically adsorbs the charged substance more strongly. Preferably, the semiconductor substrate is a silicon substrate. For example, the material for at least the top portion of the island is any of a silicon oxide, a silicon nitride, a metal oxide and a metal nitride. The width of the top portion of the island is preferably 10 $\mu$m to 200 $\mu$m. The apparatus can have an enclosure wall for holding the solution, provided on the surface of the first solid to enclose the island. Preferably, the first solid and the second solid are arranged to be adjacent to each other in a region enclosed with the enclosure wall, and the area of the surface of the top portion of the second solid is smaller than the area of the surface of the first solid in this region. The second solid can be a plurality of islands having different widths of top portions. For example, the combination of the material for the surface part of the first solid and the material for the surface part of the second solid is a combination of any of a silicon oxide and a silicon nitride, a silicon oxide and alumina, and a silicon nitride and alumina.

According to a further aspect of the present invention, an apparatus for separating a charged substance contained in a solution from the solution comprises a first member having a plurality of through holes provided at spaces from each other and a second member combined with the first member to block the plurality of through holes. A surface of the second member exposed in the through holes includes a first region and a second region. The first region and the second region are charged to surface potentials or zeta potentials different from each other when the surface comes into contact with the solution, thereby the second region electrostatically adsorbs the charged substance more strongly.

In the present invention, the first region can be a surface exposing a first material selected from a group consisting of a metal, a semiconductor and a compound thereof, and the second region can be a surface exposing a material selected from a group consisting of a metal, a semiconductor and a compound thereof substantially different from the first material. Typically, the first material is a material selected from a group consisting of silicon, a silicon oxide film and a silicon nitride film, and the second material is a material selected from a group consisting of silicon, a silicon nitride and a metal oxide film. In the apparatus, a plurality of second members can be provided, so that the single first member and the plurality of second members can be combined with each other.

In the present invention, the first region can be a surface exposing a first material selected from a group consisting of a metal, a semiconductor and a compound thereof, and the second region can be a surface exposing a material substantially different from the first material. Combinations of the first material and the second material may be different from each other between the plurality of second members.

Preferably, the second region is smaller than the first region.

The apparatus according to the present invention can further comprise means for measuring the pH of the solution containing the substance. Preferably, the pH measuring means includes a semiconductor layer, an insulating layer formed on the semiconductor layer, an enclosure wall for holding the solution on the insulating layer and a metal electrode provided on the enclosure wall to come into contact with the solution.

Typically, the charged substance is an organic molecule in the present invention. Typically, the organic molecule is a biopolymer. Typically, the biopolymer is protein.

Typically, the apparatus according to the present invention is employed for preparing a crystal of the organic molecule.

According to a further aspect of the present invention, a method of separating a charged organic molecule contained in a solution from the solution comprises a step of bringing the solution containing the organic molecule and having pH other than the isoelectric point of the organic molecule into contact with the surfaces of the plurality of types of solids of the aforementioned apparatus.

According to a further aspect of the present invention, a method of separating a charged organic molecule contained in a solution from the solution comprises steps of bringing the solution containing the organic molecule and having pH other than the isoelectric point of the organic molecule into contact with the surfaces of the plurality of types of solids of the aforementioned apparatus and maintaining the contact so that a crystal of the organic molecule grows on any of the surfaces of the plurality of types of solids.

According to a further aspect of the present invention, a method of preparing a crystal comprises steps of bringing a solution containing an organic molecule and having pH other than the isoelectric point of the organic molecule into contact with the surfaces of the plurality of types of solids of the aforementioned apparatus, and sealing the apparatus along with a precipitant and maintaining the contact so that the crystal of the organic molecule grows on any of the surfaces of the plurality of types of solids.

In the method according to the present invention, the pH of the solution containing the organic molecule brings a surface potential or a zeta potential of a reverse polarity to the organic molecule to at least one of the surfaces of the plurality of types of solids while bringing a surface potential or a zeta potential of the same polarity as the organic molecule to the surfaces of the remaining solids.

According to a further aspect of the present invention, a kit for the aforementioned apparatus comprises a first member having a plurality of through holes provided at spaces from each other, and a plurality of second members having a plurality of types of surfaces exhibiting surface potentials or zeta potentials different from each other in the solution respectively.

According to a further aspect of the present invention, an apparatus for preparing a crystal of protein contained in a solution comprises a substrate and an island, formed on a prescribed region of the substrate, consisting of a material substantially different from the substrate at least on a top portion, wherein the surface of the substrate and the surface of the island are charged to surface potentials different from each other when the island and the surface of the substrate present around the island are simultaneously brought into contact with the solution, thereby the island adsorbs a protein molecule contained in the solution and the crystal of protein growths on the island. The apparatus can have an enclosure wall provided on the substrate to enclose the island and the surface of the substrate present around the island. Preferably, the area occupied by the surface of the top portion of the island present on a portion enclosed with the enclosure wall is smaller than the area occupied by the surface of the substrate other than the island present on the portion. The top portion of the island preferably has a width allowing the crystal of protein to grow beyond the top portion of the island. For example, the width of the top portion of the island is 10 µm to 200 µm.

According to a further aspect of the present invention, an apparatus for preparing a crystal of protein contained in a solution comprises a substrate, a film formed on the substrate and an island, formed on the film, consisting of a material substantially different from the film at least on a top portion, wherein the surface of the film and the surface of the island are charged to surface potentials different from each other when the island and the surface of the film present around the island are simultaneously brought into contact with the solution, thereby the island adsorbs a protein molecule contained in the solution and the crystal of protein growths on the island. The apparatus can further comprise an enclosure wall provided on the substrate to enclose the island and the surface of the film present around the island. Preferably, the area occupied by the surface of the top portion of the island present on a portion enclosed with the enclosure wall is smaller than the area occupied by the surface of the substrate other than the island present on the portion. The top portion of the island preferably has a width allowing the crystal of protein to grow beyond the top portion of the island. For example, the width of the top portion of the island is 10 µm to 200 µm.

According to a further aspect of the present invention, an apparatus for preparing a crystal of an organic molecule contained in a solution comprises (1) a first member having a plurality of through holes provided at spaces from each other and (2) a plurality of second members bonded to the first member, while the second members include (a) substrates and (b) islands, formed on the surfaces of the substrates, consisting of a material different from the substrates at least on top portions. The islands are formed to be present inside the through holes. Preferably, the substrates consist of silicon, and the material for at least the top portions of the islands consists of a metal oxide or a silicon nitride.

According to a further aspect of the present invention, an apparatus for preparing a crystal of an organic molecule contained in a solution comprises (1) a first member having a plurality of through holes provided at spaces from each other and (2) a plurality of second members bonded to the first member, while the second members include (a) substrates, (b) films, formed on the surfaces of the substrates, consisting of a material different from the substrates, and (c) islands, formed on the films, consisting of a material different from the films at least on top portions. The islands are formed to be present inside the through holes. Preferably, the substrates consist of silicon, and the material for at least the top portions of the islands consists of a metal oxide or a silicon nitride.

Brief Description of the Drawings

Fig. 1A is a plan view showing an exemplary conventional crystallization apparatus employing vapor diffusion, and Fig. 1B is a sectional view taken along the line X'-X' in Fig. 1A.
Figs. 2A and 2B are schematic diagrams showing conventional crystal growth.
Fig. 3 is a schematic sectional view showing an exemplary apparatus according to the present invention.
Fig. 4 is a schematic sectional view showing another exemplary apparatus according to the present invention.
Figs. 5A and 5B are schematic sectional views showing apparatuses having different widths of adsorption surfaces supplied to islands respectively.

Figs. 6A and 6B are schematic diagrams showing organic molecules adsorbed and fixed to porous solid surfaces in the apparatus according to the present invention.

Fig. 7 is a schematic diagram showing organic molecules adsorbed and fixed to a porous solid surface in the apparatus according to the present invention.

Fig. 8 is a schematic diagram showing a method of anodization employed for preparation of the apparatus according to the present invention.

Fig. 9 illustrates surface potentials of two types of solid surfaces and a protein molecule contained in a solution varying with the pH of the solution.

Fig. 10 illustrates surface potentials of two types of solid surfaces and a protein molecule contained in a solution varying with the pH of the solution.

Fig. 11 illustrates pH dependency of zeta potentials of some substances.

Figs. 12A to 12C are plan views showing exemplary patterns on which a plurality of solid surfaces are arranged in the apparatus according to the present invention.

Figs. 13A and 13B are sectional views showing exemplary patterns on which a plurality of solid surfaces are arranged in the apparatus according to the present invention.

Fig. 14 is a plan view showing an exemplary apparatus having a plurality of preferred adsorption surfaces according to the present invention.

Fig. 15 illustrates crystallization performed in a plurality of apparatuses under different conditions according to the present invention.

Figs. 16A to 16D are perspective views schematically showing various shapes of islands.

Figs. 17A and 17B are perspective views showing a part of the apparatus provided with a plurality of islands.

Fig. 18A is a sectional view showing still another exemplary apparatus according to the present invention, and Fig. 18B is a plan view thereof.

Figs. 19A to 19D are schematic sectional views illustrating a method of manufacturing the apparatus shown in Figs. 18A and 18B.

Fig. 20A is a sectional view showing a further exemplary apparatus according to the present invention, and Fig. 20B is a plan view thereof.

Figs. 21A to 21D are schematic sectional views illustrating a method of manufacturing the apparatus shown in Figs. 20A and 20B.

Fig. 22A is a sectional view showing a further exemplary apparatus according to the present invention, and Fig. 22B is a plan view thereof.

Figs. 23A to 23D are schematic sectional views illustrating a method of manufacturing the apparatus shown in Figs. 22A and 22B.

Figs. 24A to 24D are schematic sectional views illustrating another method of manufacturing the apparatus according to the present invention.

Fig. 25A is a plan view showing an exemplary crystal preparation apparatus according to the present invention, and Fig. 25B is a sectional view taken along the line X-X in Fig. 25A.

Fig. 26A is a plan view showing a second substrate shown in Figs. 25A and 25B, and Fig. 26B is a sectional view taken along the line Y-Y in Fig. 26A.

Fig. 27 is a sectional view showing a solution, containing a polymer to be crystallized, held in the apparatus shown in Figs. 25A and 25B.

Figs. 28A to 28E are sectional views schematically showing exemplary structures of the second substrate used in the apparatus shown in Figs. 25A and 25B respectively.

Figs. 29A to 29C are schematic sectional views showing steps for manufacturing the substrates shown in Figs. 28A to 28E.

Figs. 30A to 30E are sectional views schematically showing specific crystallization members used for the apparatus according to the present invention.

Fig. 31A is a plan view showing another exemplary second substrate according to the present invention, and Fig. 31B is a sectional view showing another exemplary apparatus formed by combining a first substrate and the second substrate according to the present invention.

Fig. 32A is a plan view showing exemplary surface arrangement in a crystallization region, and Fig. 32B is a sectional view thereof.

Fig. 33A is a plan view showing another exemplary surface arrangement in a crystallization region, and Fig. 33B is a sectional view thereof.

Fig. 34A is a plan view showing a further exemplary apparatus according to the present invention, and Fig. 34B is a sectional view taken along the line Z-Z in Fig. 34A.

Fig. 35 is a plan view of a second substrate shown in Figs. 33A and 33B.

Fig. 36 is a sectional view showing a solution containing a polymer held in the apparatus shown in Figs. 33A and 33B.

Fig. 37A is a plan view showing an apparatus combined with a substrate for holding a precipitant, and Fig. 37B is a sectional view thereof.

Fig. 38 is a sectional view showing a mode of employment of the apparatus shown in Figs. 37A and 37B.

Fig. 39 is a sectional view showing another mode of employment of the apparatus shown in Figs. 37A and 37B.

Fig. 40 is a schematic sectional view showing an exemplary pH sensor provided on the apparatus according to the present invention.

Fig. 41 illustrates exemplary capacity-voltage characteristics measured with the pH sensor shown in Fig. 40.

Fig. 42 illustrates the relation between flat band potentials obtained from the capacity-voltage characteristics measured with the pH sensor shown in Fig. 40 and the pH values of solutions.

Fig. 43 is a schematic diagram showing a flow of pH measurement in the apparatus according to the present invention.

Fig. 44 is a perspective view showing a further exemplary apparatus according to the present invention.

Fig. 45 is a sectional view of the apparatus shown in Fig. 44.

Fig. 46 is a sectional view showing an electrode in the apparatus shown in Fig. 44 in an enlarged manner.

Figs. 47A and 47B are plan views showing the patterns of islands provided in crystal growth cells in the apparatus shown in Fig. 44 in an enlarged manner.

Fig. 48 is a perspective view showing the structure of a heating element provided in the apparatus shown in Fig. 44 in an enlarged manner.

Figs. 49A to 49E are schematic sectional views showing a method of manufacturing a base portion of the apparatus shown in Fig. 44.

Figs. 50A to 50F are schematic sectional views showing a method of manufacturing a solution holding plate of the apparatus shown in Fig. 44.

Fig. 51 is a schematic diagram showing another flow of pH measurement in the apparatus according to the present invention.

Fig. 52 is a plan view showing a further exemplary apparatus according to the present invention.

Figs. 53A to 53F are schematic sectional views showing a method of manufacturing a base, having a porous surface, of the apparatus according to the present invention.

Figs. 54A to 54F are schematic sectional views showing a method of manufacturing a solution holding plate combined with the base formed through the process of Figs. 53A to 53F.

Best Mode for Carrying Out the Invention

In a general biopolymer such as protein, intermolecular recognition is made by a geometrically specific structure and electrostatic interaction (electrostatic repulsion/attraction or van der Waals force) in a solution. In the intermolecular interaction based on electrostatic energy, it is predicted that slight difference between spatial charge distributions on the outermost surfaces of individual molecules exerts decisive influence on the degree of intermolecular recognition and easiness in formation of a molecular aggregate. In individual molecules repeating collision while making Brownian motion in the solution, therefore, it is conceivable that a nucleus of a molecular aggregate having a periodic and regular structure is extremely hard to form.

In relation to formation of a crystal of protein molecules, it is reported that the initial process of nucleation is important. When some conditions for two-dimensionally arranging molecules forming a nucleus in the initial process of crystallization are adjusted, subsequent crystallization conceivably epitaxially progresses from this nucleus.

An apparatus and a method according to the present invention can selectively adsorb organic molecules charged in a solution to a specific region of the apparatus on the basis of a working mechanism described below. Consequently, a crystal nucleus is formed on the specific region, to be capable of bringing preferable crystal growth.

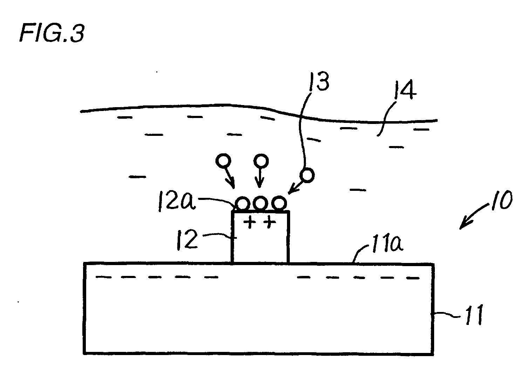

As shown in Fig. 3, an apparatus 10 according to the present invention includes a first solid 11 having a first surface 11a and a second solid 12 having a second surface 12a. The first solid 11 and the second solid 12 consist of substantially different materials. In this case, the wording "substantially different" means that the main materials forming the solids are different from each other. The materials forming the solids are metals, semiconductors or compounds thereof such as oxides, hydroxides, nitrides or the like, for example. The apparatus 10 is brought into contact with a solution 14 containing organic molecules 13 of protein or the like to be separated or crystallized. The surfaces of the organic molecules 13 are generally positively or negatively charged in a solution having pH other than the isoelectric point of the molecules when macroscopically observing the whole molecules. In the apparatus according to the present invention, the solid surfaces 11a and 12a of the aforementioned materials are also charged in the solution 14. At this time, the values and polarities of the potentials of the surfaces of the solids depend on the materials of the solids and the pH of the solution. For example, the solid surface 11a is negatively charged and the solid surface 12a is positively charged in a solution of certain pH. On the other hand, the organic molecules 13 are negatively charged in the solution of this pH. In this case, the organic molecules 13 contained in the solution 14 are selectively adsorbed to the solid surface 12a charged in the reverse polarity to the organic molecules 13 according to electrostatic attraction. Adsorption to the solid surface 11a charged in the same polarity as the organic molecules 13 is inhibited by electrostatic action. Thus, separation of the organic molecules 13 on the solid surface 12a is progressed, and preferably a crystal nucleus of the organic molecules 13 is formed for prompting crystallization. Thus, when a plurality of types of solids having different surface potentials or zeta potentials are provided in a solution containing charged organic molecules, the organic molecules can be selectively adsorbed onto the surface of any solid. Consequently, a crystal nucleus is formed on the surface of this solid, so that crystallization can be selectively progressed.

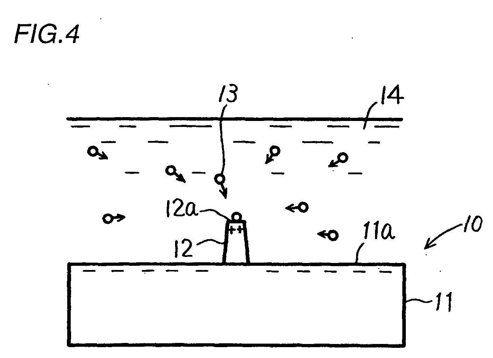

As shown in Fig. 4, another apparatus 10 according to the present invention may include a first solid 11 having a first surface 11a and an island-shaped (or convex) second solid 12 having a second surface 12a. The first solid 11 and the second solid 12 may consist of substantially different materials, or may contain a common main material. In this case, the wording "substantially different" means that the main materials forming the solids are different from each other. When both solids contain a common main material, the quantities or types of secondary materials such as impurities or minor components are generally different from each other. The materials forming the solids are metals, semiconductors or compounds thereof such as oxides, hydroxides, nitrides or the like, for example. The apparatus 10 is brought into contact with a solution 14 containing organic molecules 13 of protein or the like to be crystallized. The surfaces of the organic molecules 13 are generally positively or negatively charged in a solution having pH other than the isoelectric point of the molecules when macroscopically observing the whole molecules. In the apparatus according to the present invention, the surfaces 11a and 12a are also charged in the solution 14. At this time, the values and polarities of the potentials of the surfaces depend on the materials of the solids and the pH of the solution. For example, the solid surface 11a is negatively charged, the solid surface 12a is positively charged and the organic molecules 13 are negatively charged in a solution of certain pH. In this case, the organic molecules 13 contained in the solution 14 are selectively adsorbed to the solid surface 12a charged in the reverse polarity to the organic molecules 13 according to electrostatic attraction. Adsorption to the solid surface 11a charged in the same polarity as the organic molecules 13 is inhibited by electrostatic action. Thus, a crystal nucleus of the organic molecules 13 is formed on the solid surface 12a, for progressing crystallization. However, the first surface and the second surface may not necessarily exhibit reverse polarities in the solution. Also when the first and second surfaces are charged in the same polarity, a polymer can be more strongly attracted and adsorbed to either one of the surfaces if the quantities of charges thereof are different from each other. Thus, when the electrostatic properties of the solid surfaces in the solid are controlled, a surface capable of specifically or preferentially adsorbing or flocculating the polymer such as protein is provided. Further, influence by convection in the solution can be reduced for bringing stable crystal growth by electrostatically adsorbing the polymer to the solid surface.

As hereinabove described, the surface of the apparatus according to the present invention includes a plurality of types of regions having surface potentials (zeta potentials) of different values when brought into contact with the solution. A substance charged in the solution, such as the organic molecules, for example, is selectively adsorbed to a specific region of the surface of the apparatus due to electrostatic action. On the other hand, adsorption of the organic molecules to the remaining region of the surface is inhibited. The region for adsorbing the organic molecules is preferably sufficiently small as compared with the region inhibited from adsorbing the organic molecules. When a region (second surface) for electrostatically adsorbing the organic molecules and a region (first surface) inhibited from adsorption are formed on the surface of the apparatus, for example, the area occupied by the first surface is preferably sufficiently large as compared with the area occupied by the second surface.

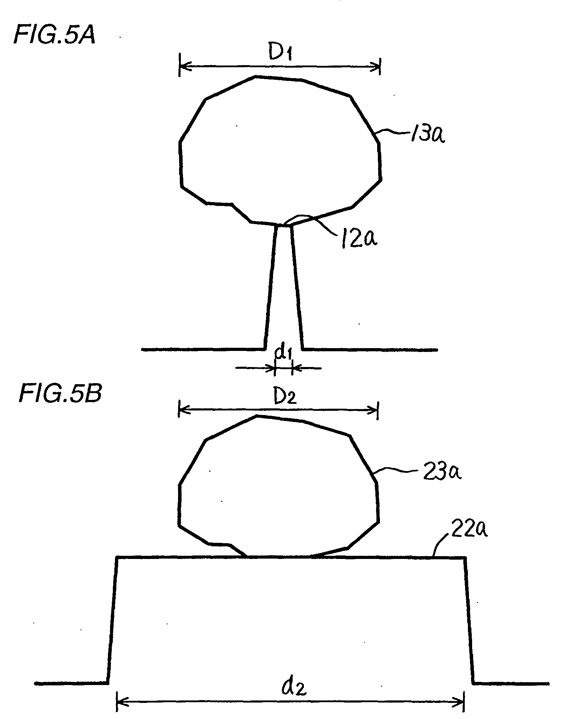

As shown in Fig. 3 or 4, the surface 12a for strongly electrostatically adsorbing the organic molecules is preferably provided on a projecting portion in the apparatus according to the present invention. Throughout the description, the projecting portion providing the surface capable of adsorbing the organic molecules is referred to as an island. As shown in Fig. 3 or 4, the island (solid 12) is provided to protrude from the surface 11a hardly adsorbing the organic molecules. The surface 12a for adsorbing the organic molecules is provided on the island. In general, this surface is provided on the top portion of the island. In addition, the surface 12a preferably has a width $d_1$ allowing a crystal 13a of the organic molecules to grow beyond the surface 12a, as shown in Fig. 5A. In other words, the width $d_1$ is preferably narrower than the size (diameter) $D_1$ of the crystal to be formed. When the width of the island surface is set in such a manner, the contact area between the growing crystal and the island surface is limited. Thus, the adsorptive force of the island surface for the crystal is limited so that the growing crystal can be readily taken out. The width $d_1$ is set in a proper range in response to the species of the molecules to be crystallized. In the case of protein, for example, a crystal having a diameter of about 0.2 to about 0.5 mm is generally suitable for X-ray crystallographic analysis, and hence a width smaller than the diameter, e.g., a width of 10 to 200 $\mu$m, is preferable, and a width of 10 to 100 $\mu$m is more preferable. When the width $d_2$ of an island surface 22a is larger than the diameter $D_2$ of an obtained crystal 23a as shown in Fig. 5B, on the other hand, adsorptive force of the island surface 22a for the crystal 23a is so excessively increased that the crystal 23a can be hard to take out. In this case, the crystal may be broken unless a careful operation is made when the crystal is sucked up and collected with a pipette, for example. When the adsorptive force of the island is limited as shown in Fig. 5A, the crystal can be readily separated from the island so that the crystal can be more easily sucked up with the pipette with no breakage.

In the apparatus shown in Fig. 3 or 4, further, at least the surface 12a of the solid 12 may be rendered porous, for selectively adsorbing the organic molecules to the porous surface 12a.

The porous surface provides an irregular topographic feature capable of readily fixing the molecules to be crystallized. The molecules electrostatically attracted as described above are engaged in concave portions of the porous surface, so that the same can be more strongly fixed. The molecules fixed to the concave portions are more hardly influenced by convection in the solution. In other words, the molecules adsorbed to the surface can be inhibited from moving by the convection. Consequently, the molecules are arranged on the surface, so that an excellent crystal nucleus can be formed. Therefore, the porous surface can grow a large-sized single crystal having excellent crystallinity. Further, the porous surface, having a larger surface area than a nonporous surface, can have a larger quantity of charges than the nonporous surface.

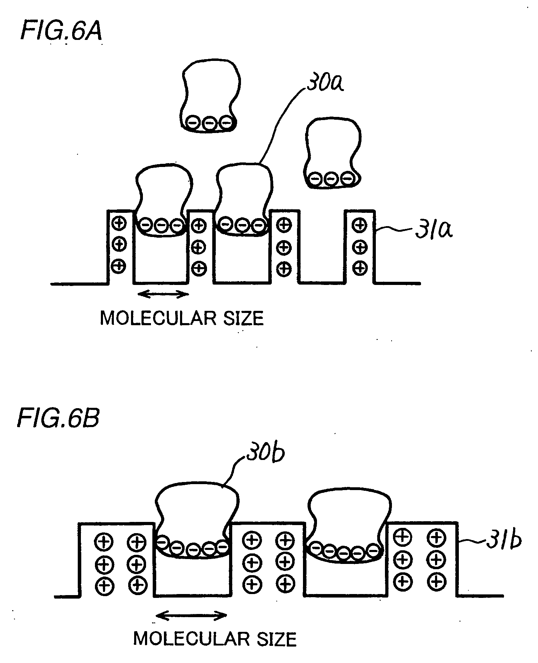

The diameter of the pores present on the surface can be rendered substantially equivalent to the size (the molecular diameter, twice the molecular radius or the maximum molecular diameter, for example) of the molecules of protein or the like to be crystallized, as shown in Figs. 6A and 6B. In this case, porous surfaces 31a and 31b can have an effect of molecular sieves. Charged molecules 30a and 30b are engaged in concave portions of the charged surfaces 31a and 31b, so that the same can be fixed by electrostatic action. It is expected that the molecules recognize specific geometric shapes of the solid surfaces and electrostatic interaction, so that an initial process of crystallization is facilitated. When the solid surfaces are prepared by two-dimensionally regularly arranging concave and convex portions as shown in Figs. 6A and 6B, it is expected that the molecules are regularly arranged along the regular arrangement of the concave and convex portions to grow excellent crystals.

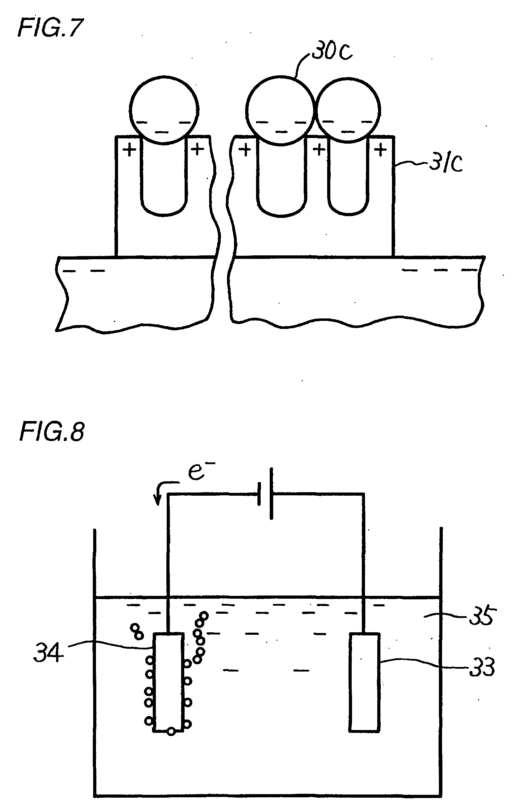

The pore diameter may alternatively be smaller than the size of molecules to be crystallized, as shown in Fig. 7. Also in this case, molecules 30c to be crystallized are partially engaged in concave portions of a surface 31c, so that the molecules 30c can be fixed to the surface 31c.

The porous surface can be formed by direct fine working employing an electron beam drawing apparatus (electron beam exposure apparatus) or an electrochemical method. A typical example of the electrochemical method is anodization. Fig. 8 shows the process of anodization. A solid to be formed with a porous surface is dipped in an electrolyte 35 as an anode 33, and current is fed between a proper cathode 34 and the anode 33. In electrolytic reaction, the anode 33 is oxidized so that a porous oxide film can be formed on its surface. A material suitable for anodization for forming this porous oxide film is aluminum or titanium.

Aluminum is a particularly preferable material. When aluminum is dipped in an acidic aqueous solution (electrolyte) of sulfuric acid, oxalic acid or phosphoric acid as an anode for performing anodization, a porous alumina film is formed in general. Pores formed at this time are homogeneously distributed substantially at regular intervals. The diameter, the depth, the interval (density), the shape etc. of the pores can be controlled by the type of the electrolyte as well as the value of applied dc voltage and the application time. While the size of a protein molecule is around or at least 10 nm, the pore diameter of an anodized film can be generally reduced to about 5 nm. In the present invention, the pore diameter of the porous surface can be set to about 5 nm to 200 nm, for example, and can preferably be set to 5 nm to 30 nm. In relation to anodization, "Advanced Metal Finishing in Japan" (Keikinzoku Shuppan)" describes a detailed technique. Japanese Patent Laying-Open No. 9-316692 discloses a technique of forming pores having a smaller diameter. When employing any technique disclosed in Japanese Patent Laying-Open Nos. 2-254192, 6-32675 and 6-200378, further, a similar porous body can be prepared also from a substance other than alumina. Each of these gazettes discloses a technique of forming an alumina porous body by anodization and transferring the shape of the obtained porous body to another material.

The material forming the apparatus according to the present invention can be selected from metals, semiconductors and compounds thereof in consideration of a mechanism described below.

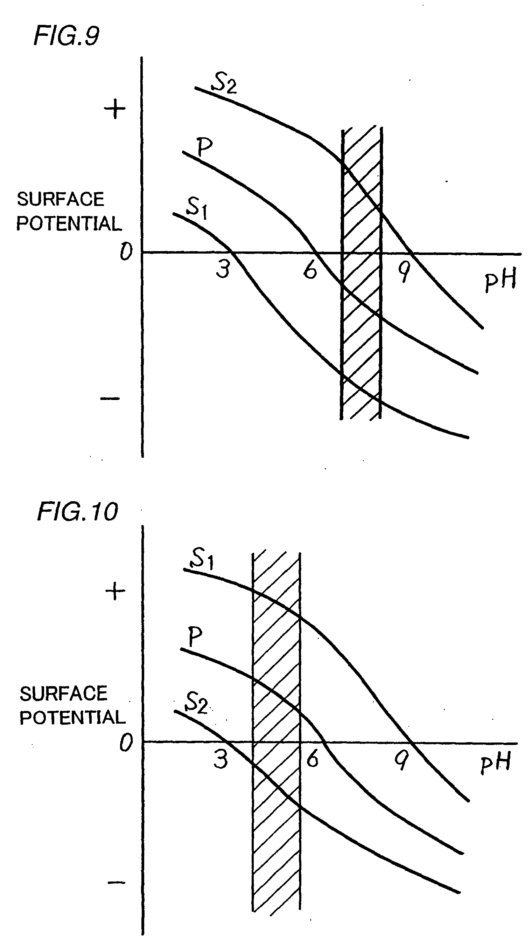

In general, the surface of a protein molecule, a colloidal grain, or a metal, a semiconductor or a compound such as an oxide, a hydroxide or a nitride thereof is charged in an aqueous solution to a surface potential (generally measurable as a zeta potential) decided by the pH of the solution. The pH value of the solution measured when this surface potential apparently reaches zero is the isoelectric point. While the isoelectric point varies with the substance, the substance is positively charged at pH lower than the isoelectric point and negatively charged at pH higher than the isoelectric point. According to the present invention, organic molecules are selectively separated or crystallized through such a property of the substance. For example, it is assumed that relation shown in Fig. 9 holds between surfaces of two solids and protein molecules to be separated or crystallized. A curve $S_1$ shows the relation between the surface potential of the first solid and the pH of the solution, a curve $S_2$ shows the relation between the surface potential of the second solid (island, for example) and the pH of the solution, and a curve P shows the relation between the surface potential of the protein molecules and the pH. The isoelectric point of the material for the surface part of the first solid is 3, the isoelectric point of the protein molecules is 6, and the isoelectric point of the material for the surface part of the second solid is 9. In a solution having pH in the region shown with slant lines (pH between the isoelectric point of the protein molecules an the isoelectric point of the surface of the second solid), therefore, the surface of the first solid and the protein molecules are negatively charged while the surface of the second solid is positively charged. In this pH region, the protein molecules are adsorbed or fixed to the surface of the second solid due to electrostatic attraction. Consequently, a crystal nucleus of protein is formed on the surface of the second solid, and crystal growth can be facilitated. On the other hand, electrostatic repulsion acts between the protein molecules and the surface of the first solid. Therefore, the protein molecules are hardly adsorbed to the surface of the first solid.

On the other hand, it is assumed that relation shown in Fig. 10 holds. In this case, the isoelectric point of the material for the surface part of the first solid is 9, the isoelectric point of the protein molecules is 6, and the surface part of the second solid (surface part of an island, for example) is 3. In a solution having pH between the isoelectric point of the surface of the second solid and the isoelectric point of the protein molecules, the surface of the first solid and the protein molecules are positively charged while the surface of the second solid is negatively charged. At pH of the region shown by slant lines, therefore, the protein molecules can be selectively adsorbed to the surface of the second solid by electrostatic attraction. Thus, when a plurality of types of solid surfaces exhibiting different charge characteristics in a solution (mother liquor) containing molecules to be crystallized are present, the molecules can be selectively electrostatically adsorbed to either solid surface (island surface, for example) by setting the pH of the mother liquor to a proper value. Consequently, a crystal nucleus can be formed on the solid surface for causing crystal growth of the molecules.

For example, the isoelectric point of silicon oxide ($SiO_2$) is 1.8 to 2.8. Therefore, a surface of $SiO_2$ is positively charged in a solution having pH lower than the isoelectric point and negatively charged in a solution having higher pH. On the other hand, the isoelectric point of alumina ($\alpha$-$Al_2O_3$) is around 9 (isoelectric point of $\gamma$-$Al_2O_3$ is about 7.4 to 8.6). Further, most protein has an isoelectric point of 4 to 7 (for example, human serum-albumin: 4.7 to 5.2, bovine insulin: 5.3 to 5.8, interferon (avian embryo): 7 to 8, human growth hormone: 4.9 to 5.2). Therefore, when the material for the first solid 11 is prepared from $SiO_2$ and the material for the second solid (island) 12 is prepared from alumina in the apparatus shown in Fig. 3 or 4, for example, the first surface 11a is negatively charged and the second surface 12a is positively charged in the solution 14 containing protein and having pH of 6 to 8 (value between the isoelectric point of protein and the isoelectric point of alumina). On the other hand, the protein molecules having the isoelectric point of 4 to 7 are negatively charged in general. Therefore, the protein molecules contained in the solution can be adsorbed to the positively charged second surface 12a. On the other hand, adsorption of the protein molecules onto the first surface 11a can be inhibited. Thus, the combination of $SiO_2$ and alumina is suitable for selective adsorption of the protein molecules.

While the isoelectric point of silicon (Si) varies with the type or the concentration of an added impurity, the isoelectric point of general n-type Si is about 3.5 to 4, for example, and an n-type Si surface is positively charged at lower pH and negatively charged at higher pH. The isoelectric point of general p-type Si is about 5 to 6. When the first solid 11 is formed by an n-type Si substrate and the second solid 12 is formed by an alumina island provided on the Si substrate in the apparatus shown in Fig. 3 or 4, therefore, the first surface 11a (n-type Si substrate surface) and the protein molecules are negatively charged and the second surface 12a (surface of the island) is positively charged in the protein solution 14 having pH of 6 to 8. Therefore, the protein molecules contained in the solution are selectively adsorbed onto the positively charged surface 12a, while absorption onto the negatively charged surface 11a can be inhibited. Thus, the combination of silicon and alumina is also suitable for selective adsorption of protein molecules.

In the apparatus according to the present invention, each solid surface consists of a metal, a semiconductor, a metal compound or a semiconductor compound. While the combination of materials forming a plurality of types of solid surfaces is arbitrary, this combination is preferably so selected that the isoelectric point of molecules to be separated or crystallized is between the isoelectric points of the materials for the plurality of types of solid surfaces. In other words, the pH-surface potential curve of the molecules to be separated is preferably between the pH-surface potential curves of the plurality of types of solid surfaces (the first solid surface and the second solid surface, for example) as shown in Figs: 9 and 10.

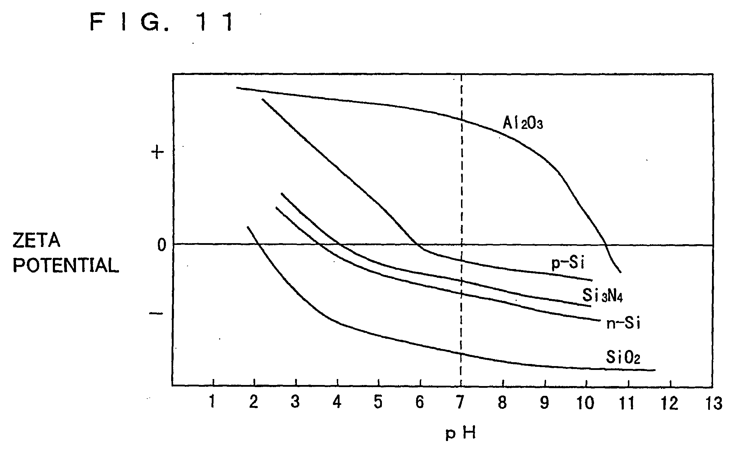

A semiconductor preferable in the present invention is silicon, gallium-arsenide (GaAs), gallium-phosphorus (GaP) or the like. A preferable semiconductor compound is silicon oxide or silicon nitride, and a preferable metal compound is a metal oxide such as aluminum oxide (($\alpha$-$Al_2O_3$ or $\gamma$-$Al_2O_3$), titanium oxide or copper oxide or a metal nitride such as aluminum nitride, titanium nitride, tungsten nitride, tantalum nitride, TaSiN or WSiN. The preferred combination of materials for the plurality of types of solids, typically the combination of materials for two types of solids is silicon and alumina, silicon oxide and alumina, silicon nitride (isoelectric point: about 4 to 5) and alumina, silicon and silicon nitride, silicon oxide and silicon nitride, silicon oxide and titanium oxide (isoelectric point: about 5 to 6.5), silicon and titanium oxide or titanium oxide and alumina. For reference, Fig. 11 shows pH dependency of surface potentials (zeta potentials as measured values) of alumina, p-type silicon, silicon nitride, n-type silicon and silicon oxide.

Such a plurality of types of solids, e.g., a first solid and a second solid (an island or a convex portion) are preferably formed on the same substrate, more preferably formed on a semiconductor substrate, and particularly preferably formed on a silicon substrate. For example, the first solid and the second solid can be formed on the same substrate by forming an alumina island only on a prescribed region of the surface of a silicon substrate. In this case, the silicon substrate corresponds to the first solid, and the alumina island corresponds to the second solid. Thus, the combination of silicon and alumina can be formed as the combination of two types of solids. Further, the combination of silicon oxide and alumina can be formed by forming a silicon oxide film ($SiO_2$ film) on the overall surface of a silicon substrate and forming an alumina island only on a prescribed region of the surface of the $SiO_2$ film. The combination of silicon nitride and alumina can be similarly formed by forming a silicon nitride film ($Si_3N_4$ film) in place of the $SiO_2$ film, and the combination of silicon and titanium oxide or silicon oxide and titanium oxide can be formed by forming an island of titanium oxide in place of the alumina island.

When a semiconductor substrate, more preferably a silicon substrate is employed, an apparatus having a plurality of types of solid surfaces can be readily prepared through techniques similar to general techniques such as CVD, photolithography and etching for fabricating a semiconductor integrated circuit. In other words, an apparatus having a plurality of solid surfaces of any combination can be prepared by forming a film of a desired material on a silicon substrate through CVD, forming a film of a different material thereon at need for providing a multilayer structure, forming a mask of a desired shape through photolithography and removing regions other than that covered with the mask through etching for exposing the underlayer. For example, the combination of silicon and alumina can be formed by forming an alumina film on the surface of a silicon substrate (including a case of forming an aluminum film and anodizing the same into an alumina film) and removing the alumina film by etching while leaving only a prescribed region for exposing the surface of the silicon substrate. Further, the combination of silicon oxide an alumina can be formed by forming a silicon oxide film on the surface of a silicon substrate, further forming an alumina film thereon and removing the alumina film by etching while leaving only a prescribed region for exposing the silicon oxide film. Thus, any type of combination can be readily formed by changing the material for the film formed on the silicon substrate.

The surface of a metal or an oxide or a hydroxide of a semiconductor hydrates when coming into contact with water, to form hydroxyl groups. The surface of the oxide or the hydroxide causes a surface potential (zeta potential) in response to the pH of the aqueous solution due to dissociation of the hydroxyl groups. For example, the following dissociation takes place in $SiO_2$:

$$\text{solid surface - Si·OH + H}^+ \rightarrow \text{solid surface - SiOH}_2^+ + \text{OH}^-$$

$$\text{solid surface - Si·OH + OH}^- \rightarrow \text{solid surface - SiO}^- + \text{H}_2\text{O} + \text{O} + \text{H}^+$$

Therefore, the surface of the oxide or the hydroxide is positively charged at low pH by proton addition, and negatively charged at high pH due to extraction of proton from OH groups. In general, an oxide or a hydroxide has a point (isoelectric point) where an apparent potential reaches zero, and has a negative surface potential at pH higher than this point while having a positive surface potential at pH lower than this point. Therefore, a combination of oxides or hydroxides having different isoelectric points can be selected and preferably employed for the present invention.

Also on the surface of a metal nitride or a semiconductor nitride, a potential responsive to the pH of an aqueous solution takes place in the aqueous solution similarly to the oxide or the hydroxide, although the detailed mechanism is unknown. For example, $Si_3N_4$, having an isoelectric point of about 4 to 5, exhibits a positive surface potential at lower pH while exhibiting a negative surface potential at higher pH.

The surface of a metal or a semiconductor also exhibits a positive surface potential in a solution having pH lower than the isoelectric point thereof while exhibiting a negative surface potential in a solution having pH higher than the isoelectric point.

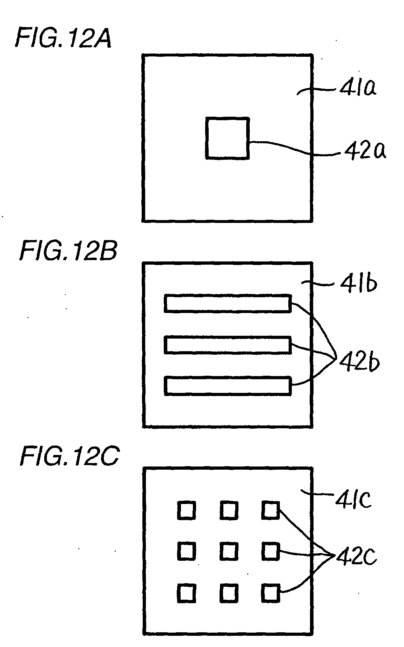

In the apparatus according to the present invention, the arrangement pattern of the plurality of types of solids is arbitrary. As shown in Fig. 12A, for example, two types of solids are preferably so arranged that a surface 42a of the second solid is enclosed with a surface 41a of the first solid in a plan view. In this case, the surface 41a of the first solid is remarkably wider than the surface 42a of the second solid. When organic molecules are adsorbed to the surface 42a of the second solid, random formation of a crystal nucleus can be effectively prevented for bringing excellent crystal growth. In other words, preferably, that the surface of the solid more strongly adsorbing the organic molecules (the surface of the second solid) is remarkably narrower than the surface of the solid capable of inhibiting adsorption of the organic molecules (the surface of the first solid) in a prescribed region of the apparatus according to the present invention. In place of those shown in Fig. 12A, a first solid and second solids may be so arranged that surfaces 42b of a plurality of second solids having prescribed widths are located at prescribed intervals with respect to a surface 41b of the first solid, as shown in Fig. 12B. Further, a first solid and second solids may be so arranged that surfaces 42c of a plurality of second solids having prescribed shapes and areas are located at prescribed intervals in the form of a matrix with respect to a surface 41c of the first solid, as shown in Fig. 12C. Referring to Figs. 12A, 12B and 12C, at least the surfaces 42a, 42b and 42c of the second solids may be rendered porous, and the pore diameters thereof are preferably substantially equivalent to or not more than the sizes of the molecules to be crystallized.

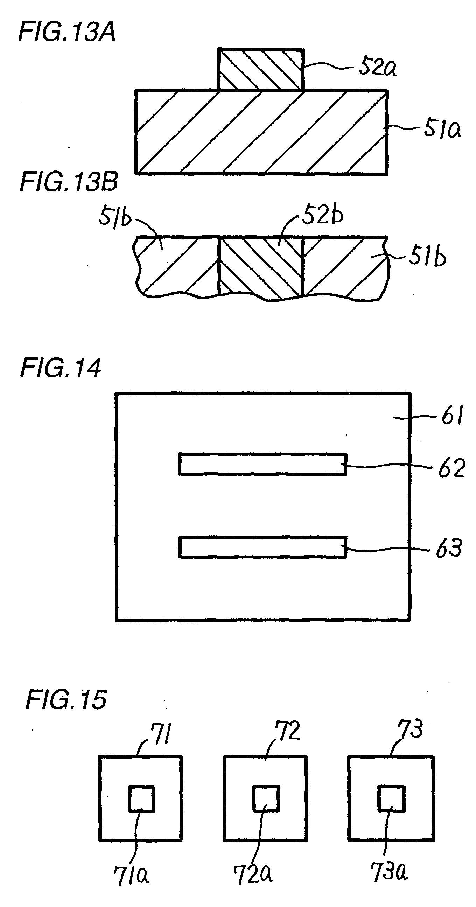

The plurality of types of solids are preferably arranged in such a multilayer structure that a second solid 52a is arranged on a first solid 51a as shown in Fig. 13A so that this structure can be prepared through a small number of steps by a method similar to that for preparing a semiconductor integrated circuit. Alternatively, such a structure that the surfaces of a plurality of types of solids 51b and 52b are provided on a prescribed surface to be flush with each other may be employed as shown in Fig. 13B.

With respect to a first solid 61, a plurality of types of second solids 62 and 63 different therefrom can be arranged as shown in Fig. 14. The solids 62 and 63 have different surface potentials with respect to a solution having prescribed pH. For example, the solid 61 can be made of silicon oxide, the solid 62 can be made of alumina, and the solid 63 can be made of titanium oxide. Specific organic molecules to be separated or crystallized can be more strongly adsorbed onto the surface of either the solid 62 or the solid 63. The optimum material for the solid (second solid) capable of more strongly adsorbing the organic molecules conceivably varies with the target organic molecules. When a plurality of types of second solids are formed as shown in Fig. 14, an apparatus singularly employable for separation and crystallization of various types of organic molecules can be provided. While the apparatus shown in Fig. 14 has two types of second solids, three or more types of second solids can alternatively be formed. Such an apparatus can also be readily prepared by a general method of fabricating a semiconductor integrated circuit. For example, an $SiO_2$ film, a $TiO_2$ film and an $Al_2O_3$ film may be successively formed and stacked on a silicon substrate, so that the $Al_2O_3$ film is removed while leaving regions of the solids 62 and 63 for exposing the underlayer $TiO_2$ film and the exposed $TiO_2$ film is thereafter removed while leaving the region of the solid 63 for exposing the $SiO_2$ film.

When the surface of the second solid is rendered porous, it is also possible to form a plurality of types of second solids having different pore diameters. The optimum pore diameter may also vary with the organic molecules similarly to the material. When a plurality of types of second solids having surfaces of different pore diameters are formed, therefore, the organic molecules are excellently selectively adsorbed onto the surface of any second solid, and excellent crystal growth on the surface can be expected.

Further, a plurality of apparatuses may be provided for separation of specific organic molecules, as shown in Fig. 15. Apparatuses 71, 72 and 73 have solids 71a, 72a and 73a consisting of different materials respectively. Separation or crystallization can be more preferably progressed in any of the apparatuses 71 to 73. It is possible to cope with separation or crystallization of a larger number of types of organic molecules by increasing the number of types of materials for simultaneously used solids.

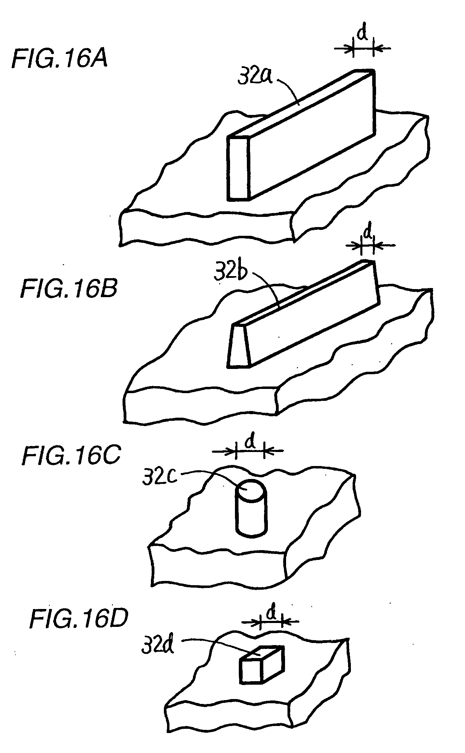

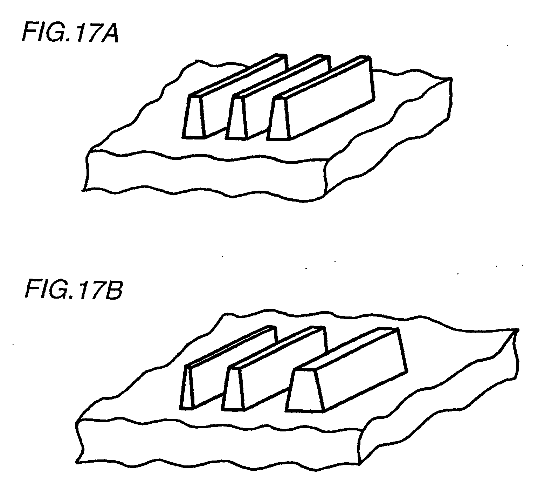

In the apparatus according to the present invention, the island can be arbitrarily shaped. For example, the island may be shaped as an elongated rectangular parallelepiped having a substantially rectangular section or an elongated pyramid having a substantially trapezoidal section, as shown in Fig. 16A or 16B. Further, the island may be substantially cylindrical as shown in Fig. 16C, or prismatic as shown in Fig. 16D. In any case, a surface 32a, 32b, 32c or 32d for adsorbing organic molecules in the island preferably has a width d allowing protrusive growth of a crystal of the organic molecules thereon. In other words, the width d is preferably smaller than the diameter of the crystal to be obtained. Further, a plurality of islands of the same shape may be provided as shown in Fig. 17A, or a plurality of types of islands having different widths may be provided in a limited range as shown in Fig. 17B. While the proper island width conceivably varies with the property of the target organic molecules or the pH, the concentration or the temperature of the solution in association with adsorptive force necessary for crystallization and easiness of taking out the growing crystal, it is expectable that crystal growth is excellently performed on any island and the growing crystal can be readily taken out when a plurality of types of islands having different widths are prepared.

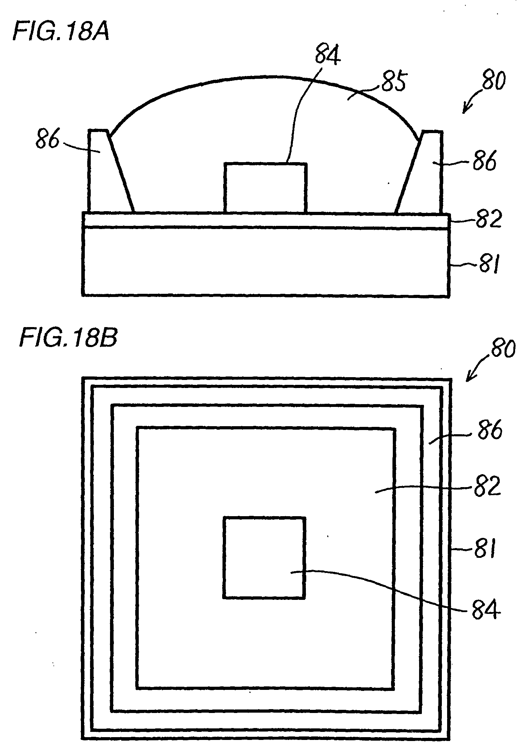

In the apparatus according to the present invention, the plurality of types of solids are preferably provided on the same base material. Figs. 18A and 18B show an example thereof. In an apparatus 80, an $SiO_2$ film 82 is formed on a silicon substrate 81, and an island 84 of $Al_2O_3$ is formed thereon. The $SiO_2$ film 82 is exposed around the island 84. An enclosure wall 86 is provided on the substrate 81, in order to hold a solution 85 on the $SiO_2$ film 82. The enclosure wall 86 is a member for interrupting the flow of the solution 85. The enclosure wall 86 defines a portion for holding the solution. This apparatus provides the aforementioned combination of silicon oxide and alumina. In other words, the $SiO_2$ film 82 corresponds to the first solid, and the island 84 corresponds to the second solid. When the solution 85 has pH of 7 to 8, the $SiO_2$ film 82 is negatively charged and the surface of the alumina island 84 is positively charged as described above. When organic molecules, contained in the solution, to be separated have an isoelectric point of 4 to 7, on the other hand, these molecules are negatively charged in general. Therefore, the molecules contained in the solution 85 are selectively adsorbed onto the positively charged island 84, and crystal growth can take place on the island 84 as a result. On the other hand, adsorption of the organic molecules onto the $SiO_2$ film 82 is inhibited. Such an apparatus can be used as a crystal growth apparatus. In such an apparatus, the alumina island may alternatively be directly formed on the silicon substrate without providing the $SiO_2$ film 82, for using the surface of the silicon substrate itself as the surface for inhibiting adsorption. Thus, the combination of silicon and alumina is provided. In this case, the silicon substrate corresponds to the first solid, and the alumina island corresponds to the second solid.

Further, another metal oxide, metal nitride, semiconductor oxide or semiconductor nitride may be used in place of alumina. In addition, a substrate of a semiconductor other than silicon or a metal may be used.

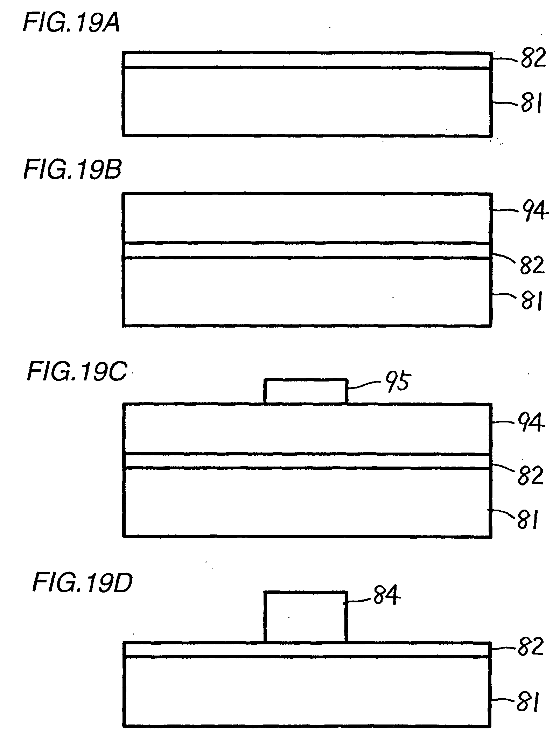

The island of the apparatus shown in Figs. 18A and 18B can be prepared through steps shown in Figs. 19A to 19D, for example. First, the $SiO_2$ film 82 is formed on the silicon substrate 81, as shown in Fig. 19B. Then, an $Al_2O_3$ film 94 is formed on the $SiO_2$ film 82, as shown in Fig. 19B. These films can be formed by vapor deposition, sputtering or the like. A resist pattern 95 shown in Fig. 19C is formed by general photolithography. Thereafter a portion not covered with the resist pattern is etched thereby obtaining the island 84 shown in Fig. 19D. When a member bringing the enclosure wall is bonded to the obtained structure, the apparatus shown in Figs. 18A and 18B is obtained. At this time, the enclosure wall is preferably made of a material, such as glass having a low isoelectric point, for example, capable of inhibiting adsorption of the organic molecules contained in the solution. However, the present invention is not restricted to this if the distance between the solid (island) for adsorbing the organic molecules and the enclosure wall is sufficiently longer than the diffusion length (the distance where the organic molecules are movable in the solution) of the organic molecules contained in the solution but the enclosure wall can be made of another material with no problem. An apparatus having solids of any combination can be obtained by varying the material for the film formed on the silicon substrate in the aforementioned steps.

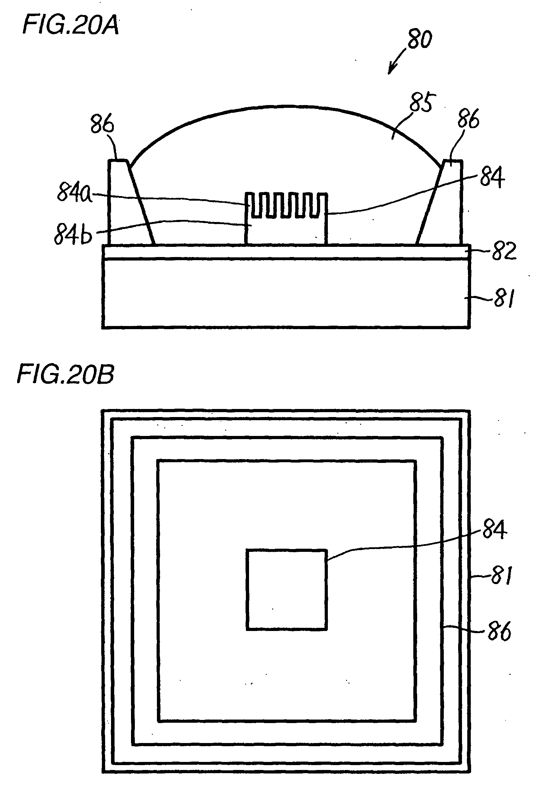

Figs. 20A and 20B show an exemplary apparatus 80 according to the present invention comprising a solid having a porous surface. In the apparatus 80, an $SiO_2$ film 82 is formed on a silicon substrate 81, and an island 84 of $Al_2O_3$ is formed thereon. The surface of the island 84 is porous. The island 85 has an alumina porous layer 84a and an alumina barrier layer 84b. The $SiO_2$ film 82 is exposed around the island 84. An enclosure wall 86 is provided on the substrate 81, in order to hold a solution 85 on the $SiO_2$ film 82. The enclosure wall 86 is a member for interrupting the flow of the solution 85. The enclosure wall 86 defines a portion for holding the solution. This apparatus provides the aforementioned combination of silicon oxide and alumina. In other words, the $SiO_2$ film 82 corresponds to the first solid, and the island 84 corresponds to the second solid. When the solution 85 has pH of 7 to 8, the $SiO_2$ film 82 is negatively charged and the surface of the porous alumina island 84 is positively charged as described above. When organic molecules, contained in the solution 85, to be separated have an isoelectric point of 4 to 7, on the other hand, these molecules are negatively charged in general. Therefore, the molecules contained in the solution 85 are selectively adsorbed onto the positively charged island 84, and crystal growth can take place on the island 84 as a result. On the other hand, adsorption of the organic molecules onto the $SiO_2$ film 82 is inhibited. Such an apparatus can be used as a crystal growth apparatus. In such an apparatus, the porous alumina island may alternatively be directly formed on the silicon substrate without providing the $SiO_2$ film, for using the surface of the silicon substrate itself as the surface for inhibiting adsorption. In this case, the combination of silicon and alumina is provided. In this case, the silicon substrate corresponds to the first solid, and the alumina island corresponds to the second solid. Further, another metal oxide, metal nitride, semiconductor oxide or semiconductor nitride may be used in place of alumina. In addition, a substrate of a semiconductor other than silicon or a metal may be used. However, the solid (the island 84 in the apparatus shown in Figs. 20A and 20B) for adsorbing the organic molecules preferably has a porous surface, and alumina obtained by anodizing aluminum is most preferable as the material for this solid for the reason that the porous surface can be readily formed by anodization.

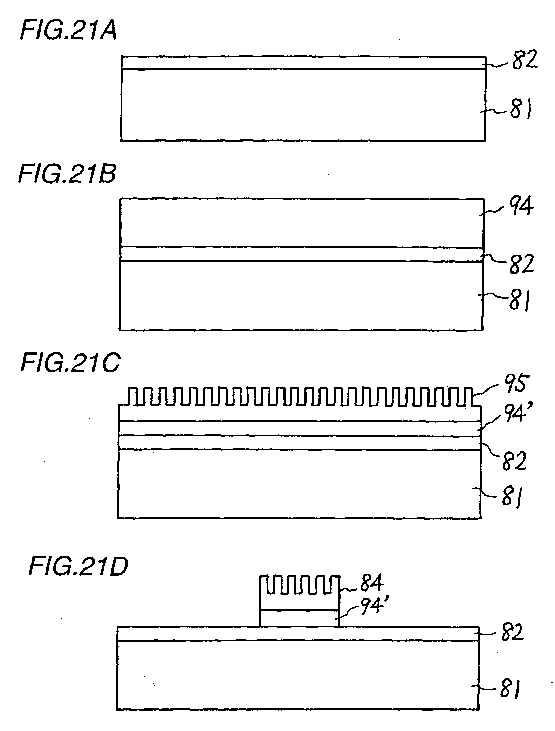

The island of the apparatus shown in Figs. 20A and 20B can be prepared through steps shown in Figs. 21A to 21D, for example. First, the $SiO_2$ film 82 is formed on the silicon substrate 81, as shown in Fig. 21B. Then, an aluminum film 94 is formed on the $SiO_2$ film 82, as shown in Fig. 21B. These films can be formed by vapor deposition, sputtering or the like. Then, anodization is performed as to the aluminum film 94 for converting at least the surface part of the aluminum film 94 to the porous alumina layer 95, as shown in Fig. 21C. An aluminum layer 94' may be left under the alumina layer 95. When this apparatus is employed for preparing a crystal of protein, however, it is desirable to entirely convert the aluminum film 94 to alumina. A buffer solution employed for crystallization of protein may dissolve aluminum. Then, a resist pattern is formed by general photolithography. Thereafter a portion not covered with the resist pattern is etched thereby obtaining the porous island 84 on the $SiO_2$ film 82, as shown in Fig. 21D. When a member bringing the enclosure wall is bonded to the obtained structure, the apparatus shown in Figs. 20A and 20B is obtained. At this time, the enclosure wall is preferably made of a material, such as glass having a low isoelectric point, for example, capable of inhibiting adsorption of the organic molecules contained in the solution. However, the present invention is not restricted to this if the distance between the solid (island) for adsorbing the organic molecules and the enclosure wall is sufficiently longer than the diffusion length (the distance where the organic molecules are movable in the solution) of the organic molecules contained in the solution but the enclosure wall can be made of another material with no problem. An apparatus having solids of any combination can be obtained by varying the material for the film formed on the silicon substrate in the aforementioned steps.

When the apparatus shown in Figs. 18A and 18B or Figs. 20A and 20B is used as an apparatus for preparing a crystal of organic molecules, the width of the island 84 is preferably narrower than the size of the prepared crystal, as described above. In the case of an apparatus for preparing a crystal of protein, for example, the width of the island is preferably set to 10 to 200 $\mu$m, more preferably to 10 to 100 $\mu$m.

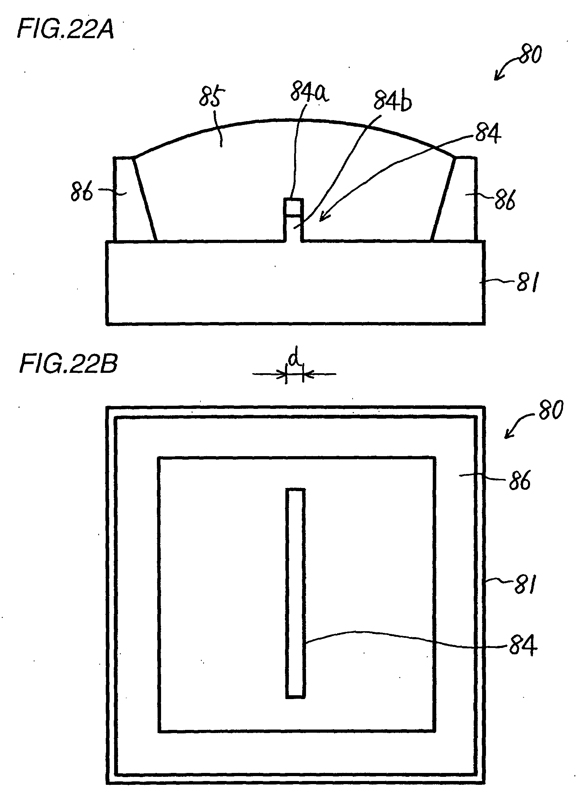

Figs. 22A and 22B show another exemplary apparatus 80 according to the present invention. In the apparatus 80, an island 84 providing a surface 84a consisting of alumina ($Al_2O_3$) is formed on a silicon substrate 81. In the island 84, a part 84b supporting the surface 84a consists of silicon. The surface of the silicon substrate 81 itself is exposed around the island 84. An enclosure wall 86 is provided on the substrate 81, in order to hold a solution 85. The enclosure wall 86 is a member for interrupting the flow of the solution 85. The enclosure wall 86 defines a portion for holding the solution. When the solution 85 has pH of 7 to 8, the surface of the silicon substrate 81 is negatively charged and the surface 84a of alumina is positively charged. When organic molecules, contained in the solution 85, to be crystallized have an isoelectric point of 4 to 7, on the other hand, these molecules are negatively charged in general. Therefore, the molecules contained in the solution 85 are selectively adsorbed onto the positively charged surface 84a, and crystal growth can take place on the surface 84a as a result. On the other hand, adsorption of the organic molecules onto the silicon substrate 81 is inhibited. The width d of the surface 84a of the island, smaller than the diameter of the obtained crystal as shown in Fig. 5A, is 100 to 200 $\mu$m, for example. In place of such an apparatus, a silicon oxide ($SiO_2$) film may be formed on a silicon substrate for forming an island of alumina thereon and using the surface of the silicon oxide film as the surface for inhibiting adsorption. Further, another metal oxide, metal nitride, semiconductor oxide or semiconductor nitride may be used in place of alumina. In addition, a substrate of a semiconductor other than silicon or a metal may be used.

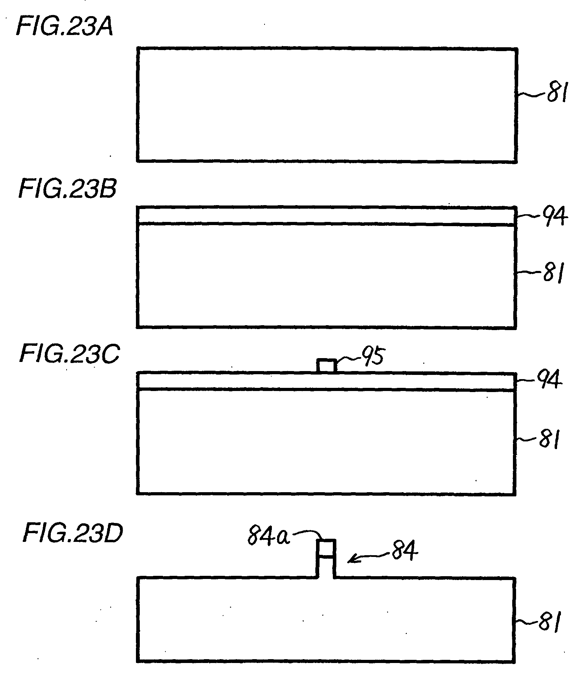

The island of the apparatus shown in Figs. 22A and 22B can be prepared through steps shown in Figs. 23A to 23D, for example. First, the silicon substrate 81 is prepared, as shown in Fig. 23A. Then, an $Al_2O_3$ film 94 is formed on the silicon substrate 81, as shown in Fig. 23B. This film can be formed by vapor deposition, sputtering or the like. Then, a resist pattern 95 shown in Fig. 23C is formed by general photolithography. Thereafter a portion not covered with the resist pattern is etched thereby obtaining the island 84 shown in Fig. 23D. The surface 84a of $Al_2O_3$ is provided on the top portion of the island 84. When a member bringing the enclosure wall is bonded to the obtained structure, the apparatus shown in Figs. 22A and 22B is obtained. At this time, the enclosure wall is preferably made of a material, such as glass having a low isoelectric point, for example, capable of inhibiting adsorption of the organic molecules contained in the solution. However, the present invention is not restricted to this if the distance between the solid (island) for adsorbing the organic molecules and the enclosure wall is sufficiently longer than the diffusion length (the distance where the organic molecules are movable in the solution) of the organic molecules contained in the solution but the enclosure wall can be made of another material with no problem.

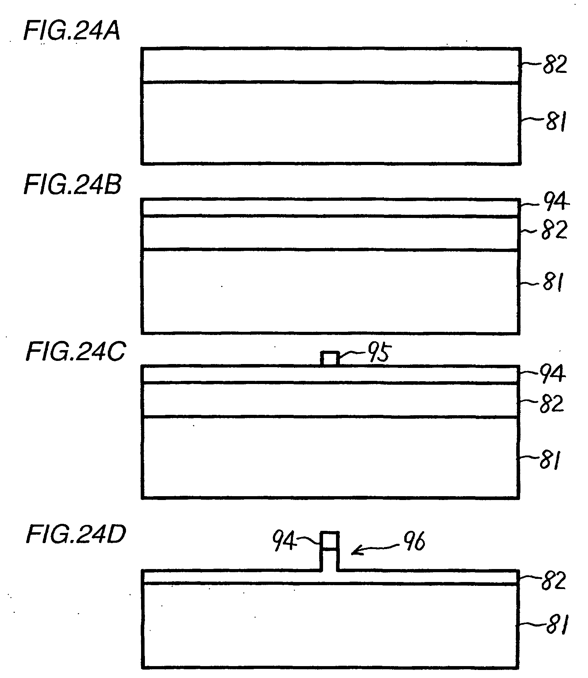

Alternatively, a silicon oxide ($SiO_2$) film 82 may be formed on a silicon substrate 81, as shown in Fig. 24A. Then, an alumina film 94 is formed on the silicon oxide film 82 as shown in Fig. 24B. After similarly forming a resist pattern 95 (Fig. 24C), etching is performed for obtaining an island 96 (Fig. 24D). In the island 96, the alumina film 94 located on the top portion is supported by the silicon oxide film 82. An apparatus having solid surfaces of any combination can be obtained by varying the material for the film formed on the silicon substrate in the aforementioned steps.

In the apparatus according to the present invention shown in Figs. 18A and 18B, Figs. 20A and 20B or Figs. 22A and 22B, the enclosure wall 86 is not necessarily required. When the surface of the apparatus brought into contact with the solution is rendered water repellent, the solution can be held on the surface through surface tension.

In order to prepare a crystal of protein, for example, with such an apparatus, the apparatus is first held in a vessel along with a precipitant. For example, the apparatus is held to be located upward beyond the liquid level of the precipitant in the vessel storing the precipitant. While an arbitrary holding method is employable, a stage may be provided in the vessel so that the apparatus is placed on the stage, for example. Then, a protein solution is dropped on a prescribed portion of the surface of the apparatus. The protein solution is dropped in the enclosure wall when the apparatus comprises the enclosure wall, or on a region including the island and the periphery thereof when the apparatus has no enclosure wall. Then, the vessel may be closed and kept in a cool dark place until the crystal sufficiently grows.

Information important for crystallization, such as the isoelectric point of the target polymer, the relation between the pH of the solution and the surface potential (zeta potential) of the polymer and the like, may not be obvious. In this case, the optimum pH of the solution and the optimum combination of the materials for the first and second solids are unobvious. Accordingly, the present invention provides an apparatus suitable for screening enabling a crystal preparation experiment simultaneously performed under a plurality of conditions for searching for conditions optimum for crystallization. Preferably, the apparatus according to the present invention has a plurality of members having the aforementioned plurality of types of solids, or has a plurality of types of combinations of materials for a plurality of types of solids in a crystallization member, in order to simultaneously set the plurality of conditions. The present invention provides an apparatus capable of simultaneously screening a number of conditions in a simple structure by combining a plurality of crystallization members or a member having a plurality of types of crystallization regions and a member having a plurality of through holes with each other. In the apparatus according to the present invention, preferable crystal growth can take place under any of the number of conditions.

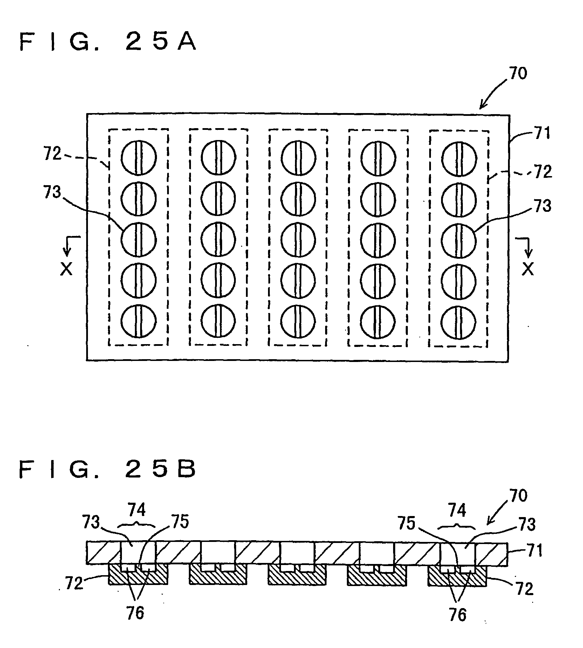

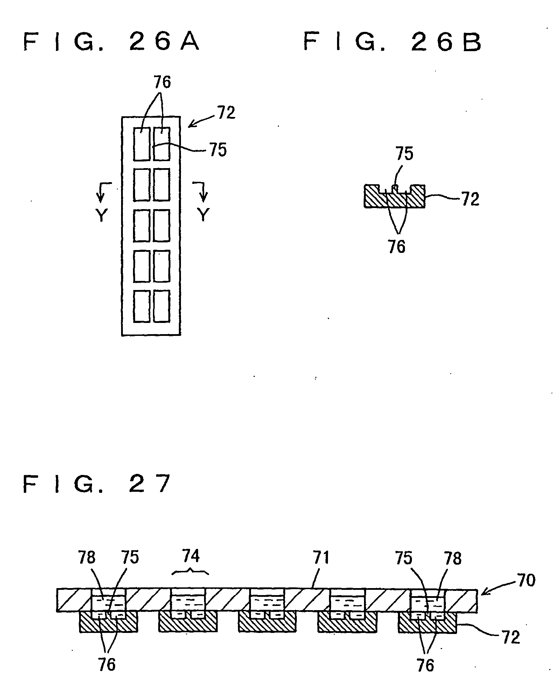

Figs. 25A and 25B show an exemplary preferable apparatus according to the present invention. An apparatus 70 for crystal preparation is an assembly of a first substrate 71 and five second substrates 72. In the case of this example, the first substrate 71 corresponds to the aforementioned member having a plurality of through holes, and the five second substrates correspond to the plurality of crystallization members. The first substrate 71 has 25 cylindrical through holes 73 arranged at spaces from each other. The substrates 72 are arranged on the respective positions where the through holes 73 are arranged. First openings of the through holes 73 are blocked with the substrates 72, while second openings are kept open. The through holes 73 blocked with the substrates 72 have portions 74 holding a solution containing organic molecules to be crystallized. In other words, the substrate 71 serves as the aforementioned enclosure wall. Each solution holding portion 74 defines a well for a crystallization test. Each substrate 72 has a shape shown in Figs. 26A and 26B. The substrate 72 has five regions 77 each having a single convex portion 75 (island) held between two concave portions 76. The regions 77 are arranged in correspondence to the arrangement of the through holes 73. The surface of the convex portion 75 and the surfaces of the concave portions 76 are made of different materials as described later, and hence these surfaces have different surface potentials (zeta potentials) in the solution held in the portion 74. Further, the surface of the forward end of the convex portion 75 is remarkably narrower than the surfaces of the two concave portions 76 holding the same therebetween. As shown in Fig. 27, a solution 78 containing a polymer to be crystallized is held in the portions 74. At this time, the surfaces of the convex portions 75 and the surfaces of the concave portions 76 simultaneously come into contact with the solution 78 and exhibit different zeta potentials in the solution 78, thereby enabling the aforementioned selective adsorption of the polymer. Assuming that a surface more strongly electrostatically adsorbing a polymer and growing a crystal of the polymer is referred to as a second surface and a surface for inhibiting crystallization is referred to as a first surface, the surfaces of the convex portions 75 and the surfaces of the concave portions 76 serve as the second surface and the first surface respectively.

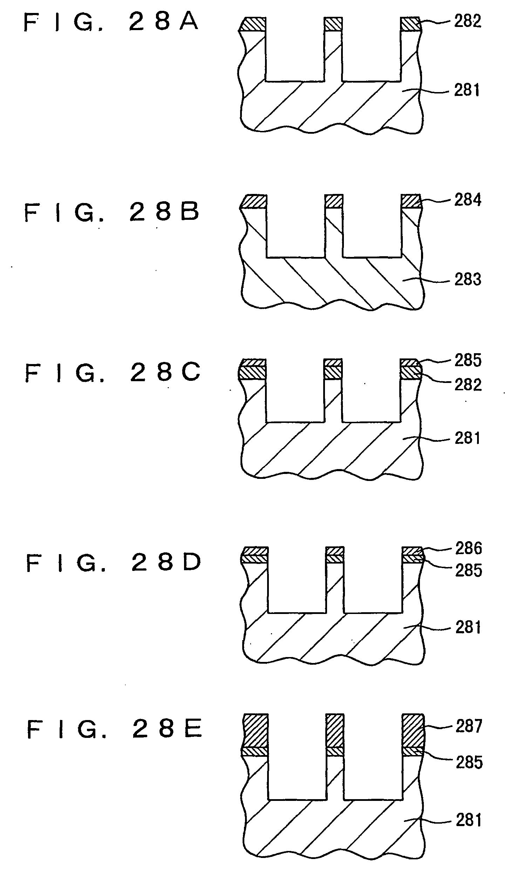

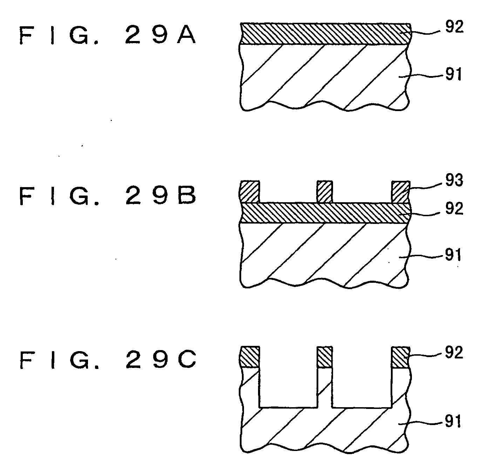

In the apparatus shown in Figs. 25A and 25B, the five substrates 72 may be totally identical to each other, or some or all of these substrates may be different from each other. For example, the five substrates may have any of structures shown in Figs. 28A to 28E. Referring to Fig. 28A, $n^+$-doped layers 282 are formed on a p-type silicon substrate 281, and hence the surface of the top of a convex portion consists of $n^+$-doped silicon and the surfaces of concave portions consist of p-type silicon. Referring to Fig. 28B, $p^+$-doped layers 284 are formed on an n-type silicon substrate 283, and hence the surface of the top of a convex portion consists of $p^+$-doped silicon and the surfaces of concave portions consist of n-type silicon. Referring to Fig. 28C, $n^+$-doped layers 282 are formed on a p-type silicon substrate 281 and silicon oxide layers 285 are further formed thereon, and hence the surface of the top of a convex portion consists of silicon oxide while the surfaces of concave portions consist of p-type silicon. In this case, the $n^+$-doped layers 282 may not be provided. Referring to Fig. 28D, silicon oxide layers 285 are formed on a p-type silicon substrate 281 and silicon nitride layers 286 are further formed thereon, and hence the surface of the top of a convex portion consists of silicon nitride while the surfaces of concave portions consist of p-type silicon. The silicon nitride layers are readily separated when the same are directly formed on the silicon substrate, and hence the silicon oxide layers are formed for improving adhesion of the layers. Referring to Fig. 28E, silicon oxide layers 285 are formed on a p-type silicon substrate 281 and alumina layers 287 are further formed thereon, and hence the surface of the top of a convex portion consists of alumina while the surfaces of concave portions consist of p-type silicon. Also in this case, the silicon oxide layers are provided as underlayers for improving adhesion of the alumina layers. When the alumina layers 287 are formed by anodization, the silicon oxide layers 285 also serve to isolate aluminum films remaining on the bottom portions from the silicon substrate. Each of the structures shown in Figs. 28A to 28E can be formed through steps shown in Figs. 29A to 29C. First, a necessary layer 92 such as a layer having a conductivity type different from that of a substrate 91, a silicon oxide layer, a silicon nitride layer or an alumina layer is formed on the substrate 91, as shown in Fig. 29A. Then, a resist pattern 93 is formed on the layer 92 by photolithography employing a proper mask, as shown in Fig. 29B. Then, a structure shown in Fig. 29C is obtained through etching, ashing or the like. Thus, regions having different surface potentials can be readily obtained by forming a necessary layer on the surface of a silicon substrate and performing general treatment such as etching.

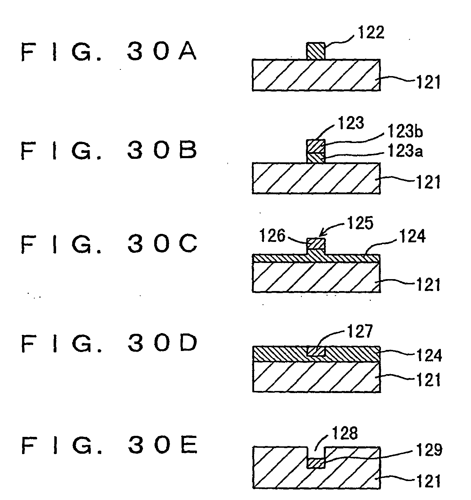

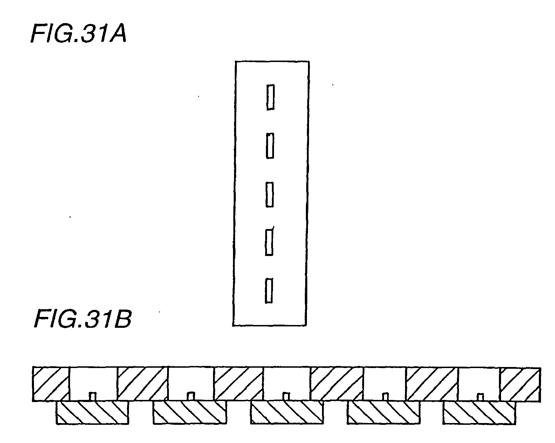

The substrate (second substrate) for crystallization to be combined with the substrate (first substrate) having a plurality of through holes can also have a structure shown in any of Figs. 30A to 30E in place of the aforementioned example. Referring to Fig. 30A, a convex portion or island 122 is formed on a substrate 121. For example, the substrate 121 consists of silicon, and the island 122 consists of silicon oxide. The island may not be totally made of the same material. Referring to Fig. 30B, for example, an island 123 formed on a substrate 121 has an underlayer 123a and an upper layer 123b. For example, the substrate 121 consists of silicon, the underlayer 123a consists of silicon oxide, and the upper layer 123b consists of alumina or silicon oxide. A material inferior in adhesion to the substrate is preferably stacked through an intermediate layer having excellent adhesion to the substrate. Referring to Fig. 30C, a layer 124 of another material is formed on a substrate 121, and an island 125 is formed thereon. In this case, the surface (first surface) of the layer 124 and the top surface (second surface) of the island 125 contribute to selective crystallization. For example, the substrate 121 consists of silicon, the layer 124 consists of silicon oxide, and an upper layer 126 of the island 125 consists of alumina or silicon nitride. A convex island may not be necessarily formed on the substrate. Referring to Fig. 30D, a layer 124 of another material is formed on a substrate 121, and another layer 127 is formed in the layer 124. The surface (first surface) of the layer 124 and the surface (second surface) of the layer 127 are flush with each other. For example, the substrate 121 consists of silicon, the layer 124 consists of silicon oxide, and the layer 127 consists of alumina or silicon nitride. Referring to Fig. 30E, a groove or hole 128 is formed in a substrate 121, and a layer 129 of another material is formed on the bottom portion thereof. Thus, a region for crystallization may be provided in a concave portion. In order to readily take out a crystal grown on a specific surface (second surface) without breaking the same, however, the area of the crystal in contact with the surface is preferably small. In consideration of this point, a convex island including a top portion having a width smaller than the size of the crystal is preferable. When the second substrate has the sectional structure shown in any of Figs. 30A to 30E, a plurality of (five in Fig. 31A) second surfaces can be shaped to be located at spaces from each other similarly to the aforementioned example, as shown in a plan view of Fig. 31A. When the second substrates are bonded to the first substrate as shown in Fig. 31B, a crystal preparation apparatus is formed similarly to the aforementioned example. When the first surface and the second surfaces of the second substrate are flush with each other as shown in Fig. 30D, the second surfaces may not necessarily be separated from each other but may be longitudinally continuous. Also in such a longitudinally continuous shape, the second surfaces are automatically separated from each other by the through holes when the second substrate is bonded to the first substrate.

As the five substrates for crystallization to be combined with the substrate having through holes, the following may be employed: (1) a substrate having a first surface of p-type silicon and a second surface of alumina, (2) a substrate having a first surface of p-type silicon and a second surface of silicon oxide, (3) a substrate having a first surface of p-type silicon and a second surface of silicon nitride, (4) a substrate having a first surface of silicon oxide and a second surface of silicon nitride and (5) a substrate having a first surface of silicon oxide and a second surface of alumina. In each of these substrates, the upper surface of an island can be employed as the second surface, and the remaining surface adjacent to the island can be employed as the first surface.

According to the present invention, various types of crystal preparation apparatuses can be readily formed in response to objects by varying the combination of the substrate (first substrate) having through holes and the substrates (second substrates) for crystallization. In relation to the apparatus shown in Figs. 25A and 25B, for example, the aforementioned five types of second substrates may be employed one by one or any of the five types of second substrates may be employed in plural. The number of the second substrates may vary with the type. For example, two types of second substrates may be employed in plural, or a plurality of single type of second substrates may be employed. The second substrates, employed in plural, may not block all through holes of the first substrate. A crystal preparation apparatus suitable to any object can be readily formed by properly selecting the second substrates to be combined with the first substrate.

In the present invention, a single second substrate is preferably formed with a plurality of crystallization regions. In the example shown in Figs. 26A and 26B, for example, five crystallization regions are formed on the substrate. The five crystallization regions of the substrate shown in Figs. 26A and 26B have the same structure. Alternatively, the plurality of crystallization regions formed on the second substrate may have different structures. In other words, the combination of a plurality of types of surfaces may be identical or different between the plurality of crystallization regions in the present invention. The apparatus shown in Figs. 25A and 25B provides 25 crystallization wells. Therefore, this apparatus can simultaneously perform a crystallization experiment under 25 types of different conditions (for example, conditions of five types of structures of crystallization regions (five types of second substrates) $\times$ five types of protein solutions) at the maximum. In a plurality of wells (wells on the same or the same types of second substrates) having the same structure of crystallization regions among the 25 wells, the crystallization experiment can be performed under different conditions by varying conditions such as the pH, the concentration of dissolved protein etc. A plurality of types of protein solutions may be fed to a plurality of wells having the same structure of crystallization regions respectively. For example, five types of protein solutions having different conditions can be fed. On the other hand, different crystallization conditions are provided to a plurality of wells (wells on different types of second substrates) having different structures of crystallization regions from the first. Protein of the same pH or the same concentration can be fed to a plurality of wells having different structures.

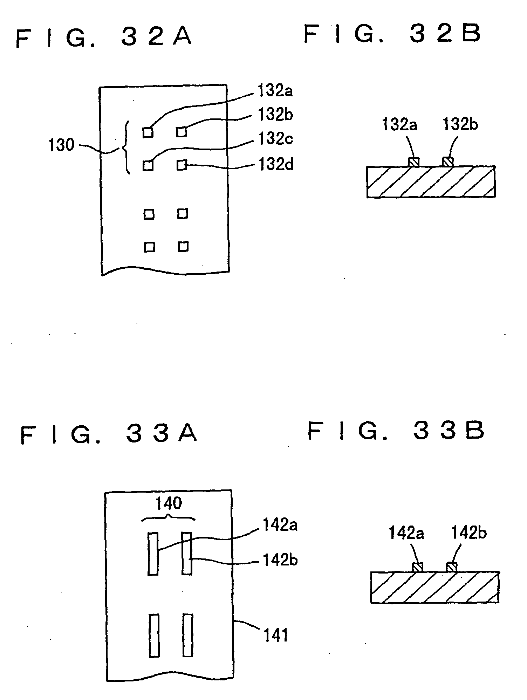

The surface (second surface) of a single island may be supplied to a single crystallization region as in the substrate shown in Figs. 26A and 26B, or the surfaces (second surfaces) of a plurality of or a plurality of types of islands may be supplied to a single crystallization region as shown in Figs. 32A and 32B or Figs. 33A and 33B. Referring to Figs. 32A and 32B, surfaces 132a to 132d of four separated islands are supplied to a single crystallization region 130. The materials for the four surfaces 132a to 132d may be identical to or different from each other. Referring to Figs. 33A and 33B, surfaces 142a and 142b of two separated islands are supplied to a single crystallization region 140. The materials for the two surfaces 142a and 142b may be identical to or different from each other. When the materials for the surfaces 142a and 142b are different from each other, three types of surfaces are supplied to the crystallization region along with the surface of a substrate 141.

When preparing a crystal of an unknown biopolymer, the number of the types of the second substrates is increased to the maximum at first so that a crystallization experiment can be performed in an apparatus having the largest possible number of physical conditions. When growth of a crystal is confirmed only on a certain single second substrate in this experiment, another crystallization experiment can be performed with an apparatus employing a plurality of only the second substrates under a number of conditions more finely varying the pH and the concentration of the solution. More proper conditions can be searched for due to this procedure.

When the apparatus shown in Figs. 25A and 25B is employed, for example, the substrates having the structures shown in Figs. 28A to 28E or the substrates having the structures shown in the above items (1) to (5) are first prepared one by one as the second substrates 72, and bonded to the first substrate 71. Assuming that crystal growth is observed only on the substrate 28D or the substrate (3) in this experiment, five substrates identical to only this substrate 28D or (3) are prepared and bonded to the first substrate 71. Then, another crystallization experiment can be performed while more finely varying conditions for the solution such as the pH and the concentration.

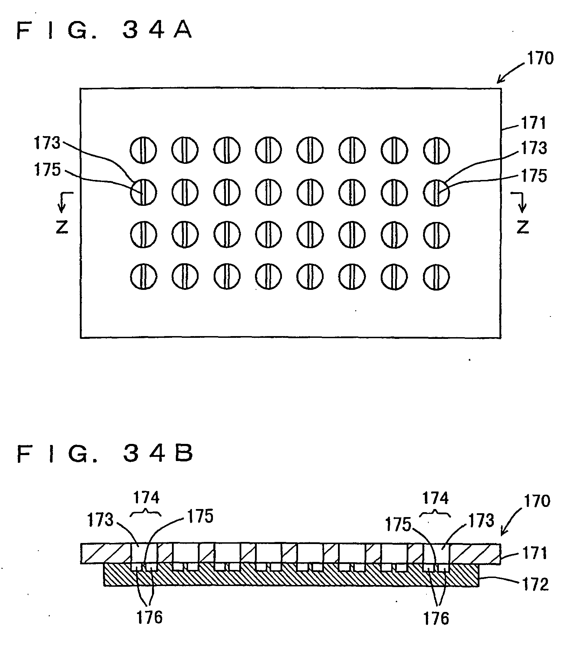

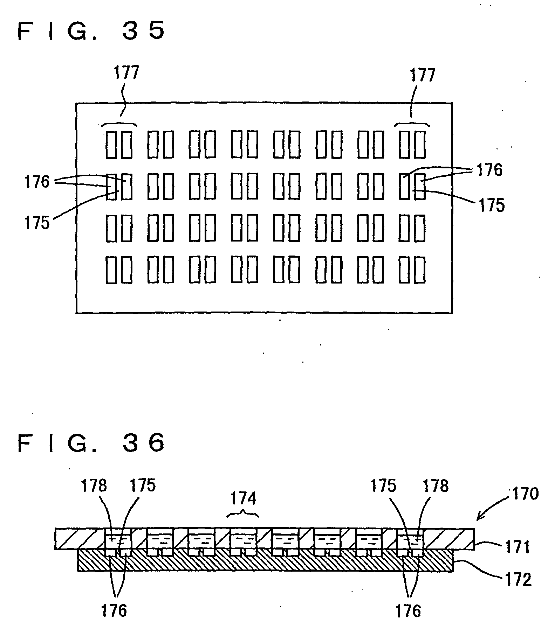

Figs. 34A and 34B show a further exemplary apparatus according to the present invention. A crystal preparation apparatus 170 is an assembly of a first substrate 171 and a second substrate 172. The first substrate 171 corresponds to the member having a plurality of through holes, and the second substrate 172 corresponds to the member having a plurality of crystallization regions. The first substrate 171 has 32 cylindrical through holes 173 separated from each other. First openings of the through holes 173 are blocked with the substrate 172, while second openings are kept open. The through holes 173 blocked with the substrate 172 define portions 174 holding a solution containing a material to be crystallized. Each solution holding portion 174 defines a well for a crystallization test. The substrate 172 has a shape shown in Fig. 35. The substrate 172 has 32 regions 177 where single convex portions 175 (islands) are held between pairs of concave portions 176. The regions 177 are arranged in correspondence to the arrangement of the through holes 173. The surfaces of the top portions of the convex portions 175 and the surfaces of the concave portions 176 are made of different materials, and hence these surfaces have different surface potentials (zeta potentials) in the solution held in the portions 174. The upper surfaces of the convex portions correspond to the aforementioned second surface, and the surfaces of the concave portions correspond to the first surface. The surfaces of the forward ends of the convex portions 175 are remarkably narrower than the surfaces of the pairs of concave portions 176 holding the same therebetween. The 32 regions 177 are classified into at least two or three types of regions. In other words, the 32 regions 177 include at least two or three types of combinations of the materials for the surfaces of the convex portions 175 and the materials for the surfaces of the concave portions 176. For example, the combinations of the materials for the surfaces may vary with the columns of the regions. In this case, eight types of combinations are present in response to the number of the columns. Alternatively, the combinations of the materials for the surfaces may vary with the rows, and four types of combinations are present in this case. The 32 regions 177 may be classified into 16 left regions and 16 right regions, or may be totally different from each other. Thus, the regions 177 may be arranged in an arbitrary combination in an arbitrary mode in response to the application thereof. The combinations of the materials for the surfaces can be selected from the combinations shown in Figs. 28A to 28E, Figs. 30A to 30E and the above items (1) to (5). The second substrate shown in Fig. 35 can also be prepared through film formation shown in Figs. 29A to 29C, photolithography, etching etc.

As shown in Fig. 36, a solution 178 containing a polymer to be crystallized is held in the portions 174. At this time, the surfaces of the convex portions 175 and the surfaces of the concave portions 176 simultaneously come into contact with the solution 174. These surfaces are charged to different zeta potentials in the solution 178, for enabling the aforementioned selective adsorption of the polymer.

The apparatus shown in Figs. 34A and 34B, also having a plurality of types of crystallization regions having different structures, simultaneously provides a plurality of crystallization conditions. This apparatus provides 32 crystallization wells. Therefore, this apparatus can simultaneously perform crystallization under 32 types of different conditions at the maximum. However, not all wells may necessarily be set under different conditions. In a plurality of wells having the same structure of crystallization regions among the 32 wells, crystallization can be performed under different conditions by varying conditions such as the pH, the concentration of dissolved protein etc. A plurality of types of protein solutions may be fed to a plurality of wells having the same structure of crystallization regions respectively. On the other hand, a plurality of wells having different structures of crystallization regions provide different crystallization conditions from the first. Protein of the same pH or the same concentration can be fed to a plurality of wells having different structures. This apparatus is also suitable for screening of optimum conditions when crystallizing a biopolymer having unknown properties.

However, it is more preferable to combine a plurality of second substrates and a first substrate with each other as shown in Figs. 25A and 25B, in consideration of generality and flexibility. A substrate having a smaller number of types of crystallization regions can be fabricated at a lower cost. When a number of the same type of second substrates are formed on a single wafer, the number of steps of film formation, photolithography, etching etc. necessary for preparing a number of substrates can be reduced.

In relation to the aforementioned apparatus, the substrate (first substrate) having a plurality of through holes consists of glass, plastic such as polycarbonate resin or acrylic resin, a metal such as stainless steel or the like. The first substrate is preferably made of a material, such as glass having a low isoelectric point, for example, capable of inhibiting adsorption of the polymer contained in the solution. The through holes can be formed in the substrate by etching employing a resist pattern, machining or the like. Alternatively, a substrate having through holes from the first can be obtained by molding raw material or the like. The substrate (second substrate) having crystallization regions is preferably formed by employing a semiconductor substrate, particularly a silicon wafer. When the silicon wafer is employed, the substrate having a plurality of types of surfaces can be readily fabricated through a general technique of fabricating a semiconductor integrated circuit. In other words, the second substrate can be readily fabricated through film formation, photolithography, etching and chemical mechanical polishing (CMP) at need. The layer of a metal oxide, a metal nitride or the like formed on the substrate can be prepared by anodization, vapor deposition such as CVD or the like.

The first substrate and the second substrate may be separably or inseparably bonded to each other. When the substrates are separably bonded, a specific second substrate can be detached from the first substrate to be replaced with another second substrate. In this case, a larger number of second substrates can be tried for a single first substrate. The first substrate and the second substrate can be bonded and fixed to each other by anode bonding or with an adhesive. When a glass substrate and a semiconductor substrate are bonded to each other, anode bonding is preferably employed. Alternatively, the first substrate and the second substrate may be bonded to each other with a sealant or an adhesive having not much strong adhesive force, to be separable from each other later. Further alternatively, the first substrate and the second substrate may be bonded to each other by an engagement structure, without through another material.

The present invention also provides a kit including the first substrate the second substrate. Any kit can be provided by combining the first substrate with a proper type of and/or a proper number of second substrates. The user of the kit can appropriately prepare a proper assembly for preparation of a crystal or screening of crystallization. In the case of such a kit, the number of second substrates combined with a single first substrate is arbitrary. A number of second substrates may be combined regardless of the number of the through holes of the first substrate. In other words, the second substrates may be combined with the first substrate in a number larger than that sufficient for blocking all through holes of the first substrate.

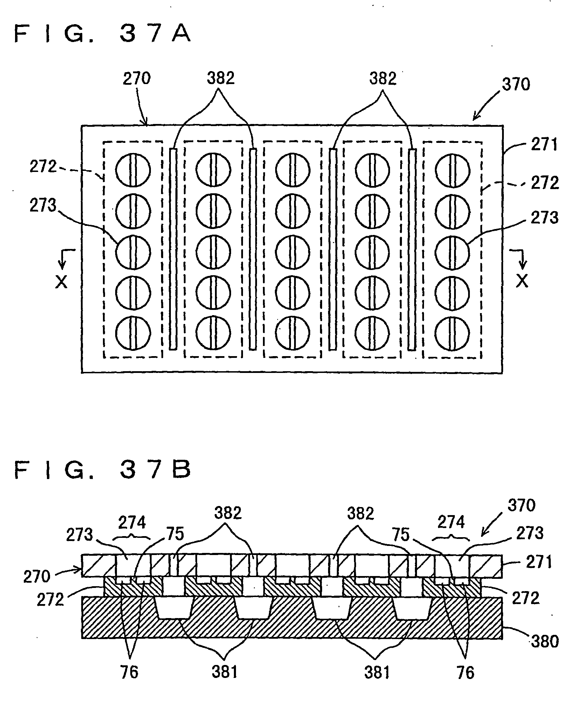

The apparatus according to the present invention formed by combining two members with each other may be combined with a third member having wells for holding a precipitant, for example. Figs. 37A and 37B illustrate an example of such an apparatus. A crystal growth apparatus 370 has an apparatus 270 having a structure similar to that of the apparatus 70 shown in Figs. 25A and 25B and a third substrate 380 bonded thereto. The third substrate 380 is made of glass or plastic. A plurality of depressions formed in the third substrate 380 are wells 381 for storing a precipitant. The apparatus 270 is an assembly of a first substrate 271 and five second substrates 272. The first substrate 271 has 25 cylindrical through holes 273 arranged at spaces from each other. The substrates 272 are arranged on the respective positions where the through holes 273 are arranged. First openings of the through holes 273 are blocked with the substrates 272, while second openings are kept open. The through holes 273 blocked with the substrates 272 define portions 274 holding a solution containing organic molecules to be crystallized. Each solution holding portion 274 defines a well for a crystallization test. Each substrate 272 has the shape shown in Figs. 26A and 26B. The first substrate 271 has through holes 382 on positions opposed to respective wells 381 of the third substrate 380. In the first substrate 271, the respective through holes 382 are provided on portions not connected with the second substrates 272. The second substrates 272 and the third substrate 380 can be connected with each other by anode bonding, for example. The precipitant can be fed into the wells 381 through the through holes 382.

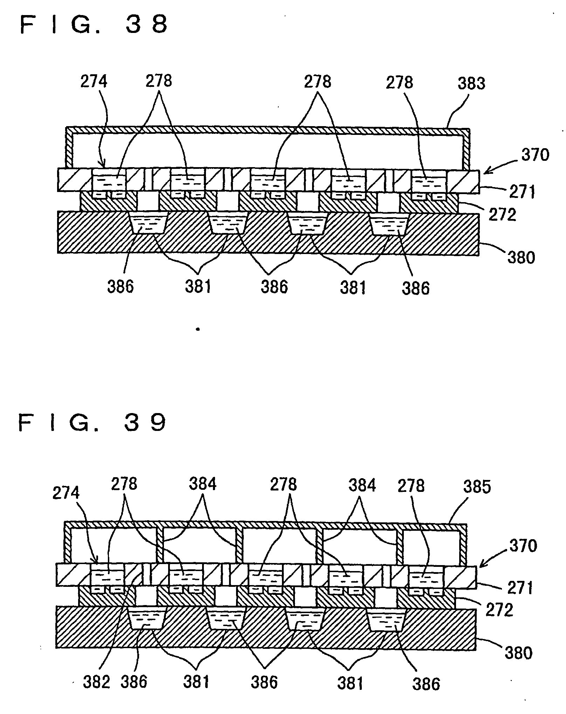

Figs. 38 and 39 show exemplary uses of the apparatus shown in Figs. 37A and 37B. Referring to Fig. 38, a solution 278 containing protein to be crystallized is stored in the solution holding portions 274, and a precipitant 386 is stored in the wells 381 of the third substrate 380. The crystal growth apparatus 370 is covered with a glass lid 383, so that the solution 278 and the precipitant 386 are set in a closed space. Referring to Fig. 38, influence by the precipitant stored in a single well can be exerted on the overall apparatus. Referring to Fig. 39, on the other hand, a glass lid 385 covering the crystal growth apparatus 370 has partitions 384. The partitions 384 keep the respective solution holding portions 274 in states independent of each other. In other words, the partitions 384 define a plurality of compartments for crystallization. Each compartment has the solution holding portion 274, the well 381 and the through hole 382. The solution 278 stored in the holding portion 274 is influenced by only the precipitant 386 held in the well 381 immediately close thereto. When varying the type of the precipitant with the well, therefore, crystallization conditions varying with columns of the apparatus 370 can be formed.

The apparatus according to the present invention can include means for measuring the pH of the solution. The pH of the solution influences the surface potentials or effective surface charges of the surfaces of the solids and the organic molecules to be separated as hereinabove described, and hence it is meaningful to monitor the pH of the solution in the operation of separation or crystallization. A general pH meter, a conventional pH sensor prepared by combining an ion-sensitive field-effect transistor (ISFET) with a reference electrode or the like can be employed for the pH measuring means.

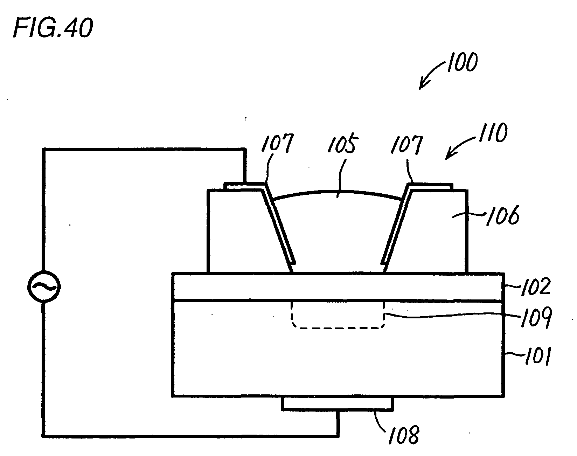

Alternatively, an apparatus shown in Fig. 40 may be employed as the pH measuring means. In a pH measuring apparatus 100, an $SiO_2$ film 102 is formed on an n-type silicon substrate 101. A solution holding portion 110 is provided on the substrate 101. The solution holding portion 110 is formed by an enclosure wall 106 interrupting a flow of a solution 105 and the $SiO_2$ film 102. A metal electrode 107 is provided on the enclosure wall 106. The metal electrode 107 extends toward the $SiO_2$ film 102, and is arranged to come into contact with the solution stored in the solution holding portion 110. A terminal electrode 108 is provided on the back surface (surface opposed to the surface provided with the $SiO_2$ film 102) of the silicon substrate 101.

The surface of an oxide hydrates as hereinabove described, to form hydroxyl groups. Charges are caused on the surface of the oxide due to dissociation of the hydroxyl groups. Therefore, a surface potential responsive to the pH of the solution is caused on the surface of the oxide. In the case of $SiO_2$, for example, the following dissociation takes place and the surface potential varies with the pH.

$$Si \cdot OH_2^+ + OH^- \Leftrightarrow H^+ + Si \cdot OH + OH^- \Leftrightarrow Si \cdot O^- + H_2O + H^+$$

low pH      isoelectric point      high pH

A surface potential is also caused in another oxide by a similar mechanism, and the isoelectric point and the value of the caused potential vary with the type of the oxide. The isoelectric point of $SiO_2$ is about 1.8 to 2.8. Also on the surface of a nitride, a potential is caused in an aqueous solution in response to the pH of the aqueous solution similarly to the oxide, although the detailed mechanism is unknown. For example, $Si_3N_4$, having an isoelectric point of about 4 to 5, exhibits a positive potential at lower pH while exhibiting a negative surface potential at higher pH. Therefore, a nitride film such as an $Si_3N_4$ film may be employed as an insulating layer in place of the $SiO_2$ film.

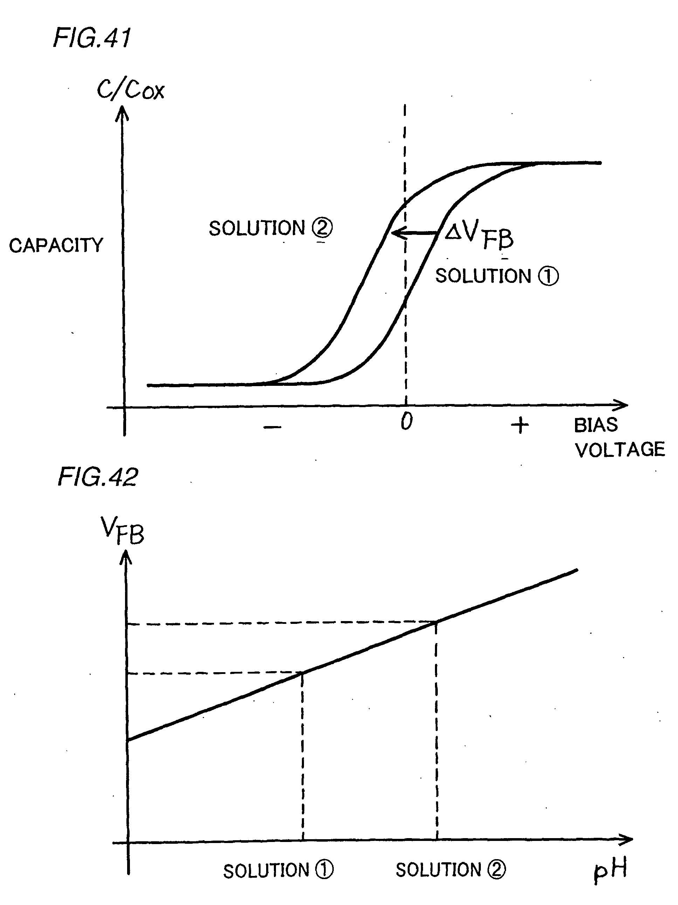

When an aqueous solution is introduced into the solution holding portion 110 exposing the $SiO_2$ film 102 in the apparatus 100 shown in Fig. 40, therefore, a potential responsive to the pH of the aqueous solution is generated on the surface of the $SiO_2$ film 102. The carrier concentration on the surface of the silicon substrate provided through the oxide film is changed by this potential. Therefore, the capacity of a depletion layer 109 formed on a portion of the silicon substrate 101 close to the solution 105 is changed (width of the depletion layer is changed). In the apparatus 100 having a structure corresponding to a MOS (MIS) structure, therefore, capacity-voltage characteristics (high-frequency characteristics) between the metal electrode 107 and the terminal electrode 108 vary with the pH of the solution 105. Fig. 41 shows this change. Fig. 41 shows capacity-voltage characteristics in relation to two types of solutions having different pH values. The capacity-voltage characteristics change along the voltage axis direction in response to the pH values, as shown in Fig. 41.

The relation between pH values and flat band potentials ($V_{FB}$) can be obtained by previously measuring capacity-voltage characteristics of various solutions having known pH values with the pH measuring apparatus shown in Fig. 40 at a measuring frequency of about 1 MHz. The pH values and the flat band potentials ($V_{FB}$) are in relation shown in Fig. 42, for example. The pH of an unknown solution is obtained on the basis of this relation. The pH measuring apparatus 100 is connected to a C-V meter and a C-V recorder. Then, the solution to be measured is introduced into the solution holding portion 110, for measuring the C-V characteristics between the electrodes 107 and 108 and obtaining the flat band potential $V_{FB}$. The pH of this solution is decided from the obtained flat band potential $V_{FB}$ and the previously obtained relation between the pH value and the flat band potential ($V_{FB}$).

In this pH measuring apparatus, a p-type Si substrate may be employed in place of the n-type Si substrate, or still another semiconductor substrate such as a compound semiconductor substrate such as a Ge substrate or a GaAs substrate, for example, may be employed. Further, another oxide film such as an $Al_2O_3$ film or a $TiO_2$ film, for example, may be employed in place of the $SiO_2$ film, or a nitride film such as an $Si_3N_4$ film may be employed. The thickness of the insulating layer is 100 Å to 1 μm, for example, and preferably 500 Å to 3000 Å. Pt, Pd, Au or the like can be employed as the material for the electrodes.

This pH measuring apparatus has an extremely simple structure (MOS (MIS) structure), and can be readily fabricated through general semiconductor working techniques (lithography, CVD, etching etc.). The pH of a solution prepared in an extremely small amount of several μl to several 10 μl can be measured by dropping the solution on the solution holding portion of this apparatus with a pipette or the like. This apparatus can be prepared on a silicon substrate, so that the same can be formed on the same substrate as the separation apparatus according to the present invention. In the case of the apparatus shown in Figs. 25A and 25B, for example, this pH measuring apparatus can be formed on one of the five second substrates 72.

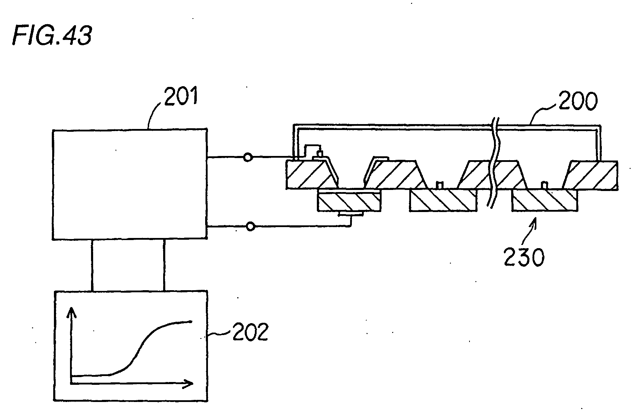

In order to prepare a crystal of protein while monitoring the pH of a protein solution with such an apparatus, the protein solution is fed to each well of an apparatus 230 and each well is closed with a transparent glass lid 200 as shown in Fig. 43, so that the apparatus 230 is kept in a cool dark plate. The state of crystal growth in each well can be observed from above the transparent lid with a microscope. At this time, a C-V meter 201 is connected to electrodes of a pH monitor cell, for measuring C-V characteristics with an X-Y recorder 202, as shown in Fig. 43. Thus, the pH of the solution can be monitored during crystal growth.

In order to prepare a crystal of organic molecules such as a crystal of protein, for example, with the apparatus according to the present invention, a protein solution may be fed into each well of the apparatus and the apparatus fed with the solution may be closed along with a precipitant. The precipitant may be stored in another vessel and arranged in line with the crystal growth apparatus. While a pH monitor is not necessarily required, a crystal growth well, a pH monitor well and a precipitant cell are preferably prepared on the same substrate to form a single chip in view of convenience. Such a one-chip apparatus can be readily fabricated through a general fabrication process for a semiconductor device as described above.

Example 1

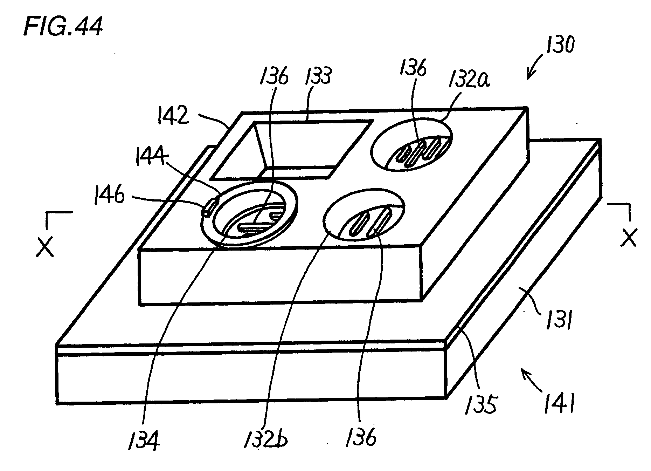

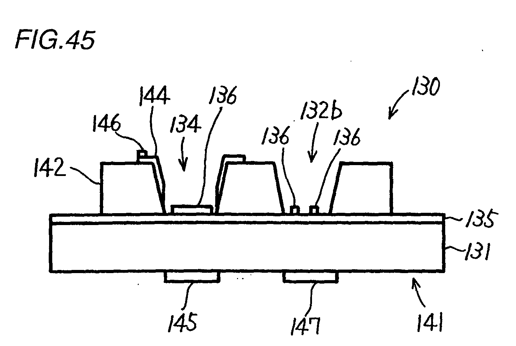

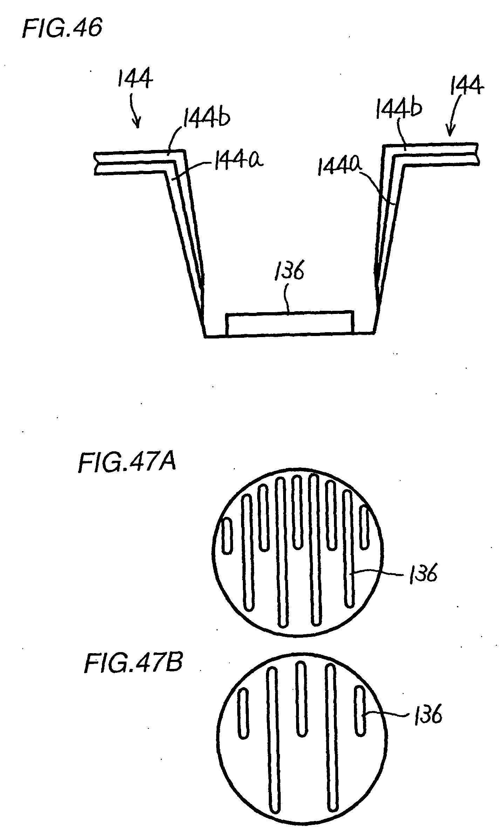

An apparatus shown in Figs. 44 and 45 was prepared. The apparatus 130 has a base 141 including a silicon substrate 131 and a solution holding plate (enclosure wall) 142 of Pyrex glass bonded thereto. The base 141 is 15 mm by 15 mm in size. The base 141 and the plate 142 define two crystal growth cells 132a and 132b, a single precipitant cell 133 and a single pH monitor cell 134. The plate 142 is 12 mm by 12 mm in size, and 0.5 mm in height. The surface of the silicon substrate 131 is covered with a silicon oxide film 135. The cells 132a, 132b and 134 have cylindrical or conical shapes of about 4 mm in diameter, and the cell 133 has a prismatic shape of 5.5 mm by 5.5 mm. In the crystal growth cells 132a and 132b and the pH monitor cell 134, a plurality of alumina islands 136 are formed on the silicon oxide film 135. The islands 136 have linear shapes as shown in Figs. 47A and 47B, and the width thereof is about 100 $\mu$m to 200 $\mu$m. The distances between adjacent ones of the islands are about 0.2 mm to 1 mm. The intervals between the islands vary with the positions in the cells or the cells. For example, the islands of the pattern shown in Fig. 47A are formed in the cell 132a, and the islands of the pattern shown in Fig. 47B are formed in the cell 132b. An electrode 144 is formed on a portion of the plate 142 for the pH monitor cell 134, and an electrode 145 is formed also on the back surface of the silicon substrate 131. As shown in Fig. 46, the electrode 144 is in a two-layer structure having a Ti layer 144a and a Pt layer 144b. A terminal 146 for external connection is provided on the electrode 144. The silicon substrate 131, the silicon oxide film 135, the electrode 144 and the electrode 145 form a pH sensor part. In the apparatus shown in Figs. 44 and 45, the islands 136 in the pH monitor cell 134 are not necessarily required. Further, a heating element 147 for heating the cells 132a and 132b at need is provided on the back surface of the silicon substrate 131 in a position opposed to the crystal growth cell. The heating element heats the solution and controls growth of the crystal.

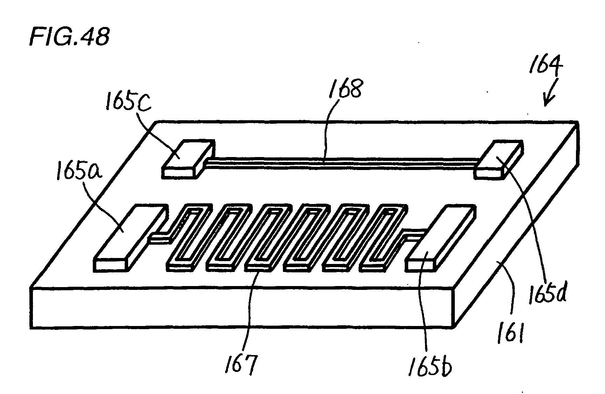

Fig. 48 shows an exemplary preferred heating element. In a heating element 164, pads 165a and 165b are formed on a base 161. A compactly folded heating wire 167 is provided between the pads 165a and 165b. The pads 165a and 165b and the heating wire 167 are thin films formed on the base 161. A silicon substrate, a glass substrate or the like can be employed for the substrate 161. The pads 165a and 165b are thin films consisting of a good conductor such as aluminum or copper, and the heating wire 167 is a thin film consisting of an electrothermal material such as Cr, an Fe-Cr-Al-based alloy, an Ni-Cr-based alloy or the like. A resistance wire 168 for temperature measurement is provided adjacently to the heating wire 167. Pads 165c and 165d are provided on both ends of the resistance wire 168. The pads 165c and 165d are thin films consisting of a good conductor such as aluminum or copper, and the resistance wire 168 is a thin film consisting of a resistive material such as Cr, a copper-manganese alloy, a copper-nickel alloy or the like. When strict temperature control is necessary, the resistance wire for temperature measurement is preferably provided adjacently to the heating wire, as shown in Fig. 48. For example, the thickness of the heating wire 167 is 0.1 $\mu$m to 1.0 $\mu$m, and the thickness of the pads 165a to 165d is 0.5 $\mu$m to 2.0 $\mu$m. The width of the heating wire 167 is 50 $\mu$m to 100 $\mu$m, for example. In order to correctly measure the temperature of the heating element, on the other hand, the thermal capacity of the resistance wire 168 is preferably minimized. Therefore, the size of the resistance wire 168 is preferably minimized in a necessary range. For example, the width of the resistance wire 168 is preferably not more than 10 $\mu$m, e.g., 1 to 10 $\mu$m. The thickness of the resistance wire 168 is preferably not more than 0.3 $\mu$m, e.g., 0.1 to 0.3 $\mu$m.

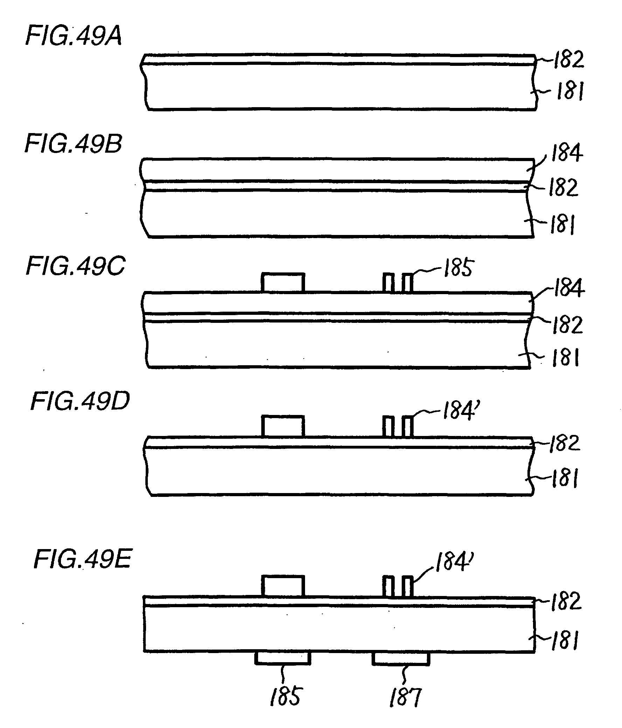

A number of the bases of the apparatuses shown in Fig. 44 can be simultaneously formed on a silicon wafer through a general fabrication process for a semiconductor device. As shown in Fig. 49A, for example, a silicon oxide film 182 of about 200 nm in thickness is first formed on the surface of a silicon wafer 181 by thermal oxidation. Then, an alumina film is formed on the silicon oxide film 182 by sputtering or CVD or an aluminum film formed by sputtering or vapor deposition is oxidized for forming an alumina film 184 of about 3 to 5 $\mu$m in thickness as shown in Fig. 49B. This alumina film 184 may be further reduced in thickness to about 1 $\mu$m. Then, a resist pattern 185 is formed on the alumina film 184 along general photolithography, as shown in Fig. 49C. The alumina film is partially removed by etching through a mask of generally employed resist while leaving only island portions. Thus, alumina islands 184' are formed on the silicon oxide film 182, as shown in Fig. 49D. Thereafter the silicon wafer is cut (scribed), an electrode 185 and a heating element 187 are provided at need on the obtained chip, thereby obtaining a number of bases (Fig. 49E).

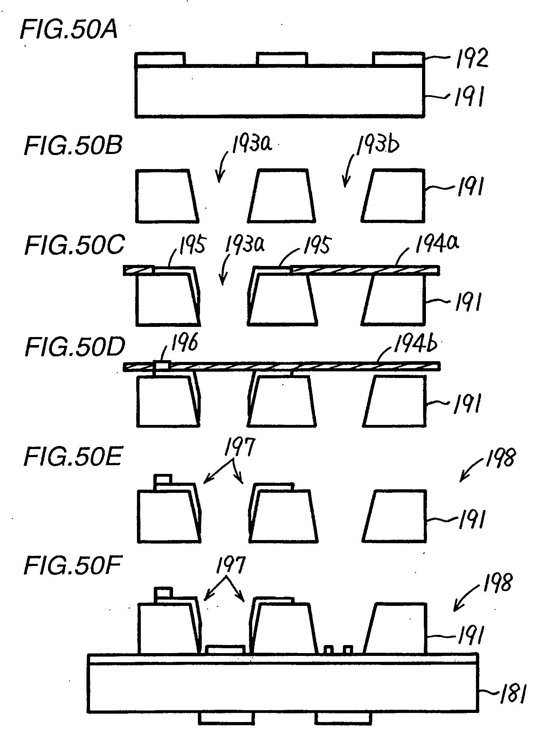

The solution holding plate is also prepared as shown in Figs. 50A to 50F, for example, through general etching and sputtering. First, a resist mask 192 is formed on the surface of a Pyrex glass plate 191 in a prescribed pattern, as shown in Fig. 50A. Then, through holes 193a and 193b are formed in the glass plate 191 by wet etching with hydrofluoric acid or diamond blasting (Fig. 50B). Then, a portion excluding the through holes 193a for defining a pH monitor cell is covered with a hard mask 194a of a stainless-steel plate, for forming a Ti/Pt film 195 by sputtering (Fig. 50C). Thereafter a necessary portion is covered with a hard mask 194b for forming an Au terminal 196 for connection by sputtering (Fig. 50D). Thus, a solution holding plate 198 having an electrode part 197 shown in Fig. 50E is obtained. The obtained plate is connected to the base obtained through the process shown in Figs. 49A to 49E by anode bonding or the like, for obtaining the apparatus (Fig. 50F).

In the apparatus 130 shown in Fig. 44, a crystal of protein is prepared by the following method: First, a solution (mother liquor) dissolving target protein is dropped on the crystal growth cell and the pH monitor cell by about 10 μl, for example. The concentration of the protein in the solution is about 10 to 50 mg/ml. The optimum concentration varies with the type of the target protein. In order to crystallize unknown protein, a plurality of types of solutions having different concentrations may be prepared so that a plurality of apparatuses are prepared therefor for simultaneously performing crystal growth. At this time, the pH of the solution is adjusted to be higher than the isoelectric points of protein and a silicon oxide and lower than the isoelectric point of alumina. The pH of the solution is adjusted by adding a buffer solution. The isoelectric point of the silicon oxide is about 2, and that of alumina is about 9. When the isoelectric point of the target protein is about 7, therefore, the pH of the solution is adjusted to about 8. Thus, protein and the silicon oxide film exhibit negative surface potentials, while alumina exhibits a positive surface potential. The optimum pH of the solution also varies with the target protein. Therefore, a plurality of types of solutions having different pH values are preferably prepared for simultaneously performing crystallization with respect to these. A precipitant is introduced into the precipitant cell. For example, a mixture of 2 ml of an NaCl solution of 1 M and 2 ml and a standard buffer solution having pH of 4.6 is prepared and dropped into the precipitant cell by about 20 μl.

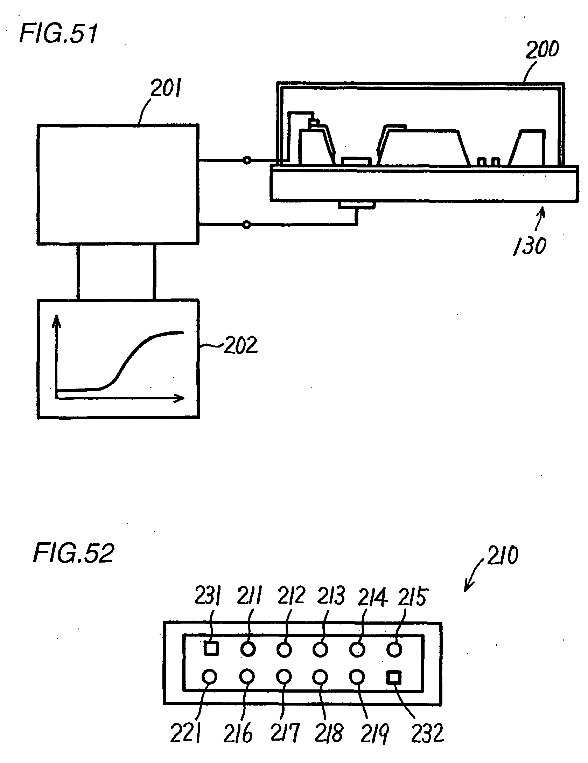

As shown in Fig. 51, the cells of the apparatus 130 are closed with the transparent glass lid 200, and the apparatus 130 is kept in a cool dark place for about 100 hours. Protein molecules are gathered and fixed to the alumina island part due to electrostatic attraction. A crystal nucleus of protein is formed on the island part, and crystal growth progresses. The state of the crystal growth is observed with a microscope from above the transparent lid. At this time, a C-V meter 201 is connected to electrodes of the pH monitor cell for measuring C-V characteristics with an X-Y recorder 202, as shown in Fig. 51. The pH of the solution is changeable during crystal growth although the same is previously adjusted. Crystallinity of protein can be influenced by slight change of the pH of the solution. Therefore, it is important to grasp slight change of the pH in the actual process of crystal growth.

When applied to a crystal preparation apparatus, the apparatus according to the present invention may have at least a single crystal growth cell. The precipitant may be introduced into another vessel and put in line with the crystal preparation apparatus, and the pH monitor is not necessarily required.

When an apparatus having a larger number of cells is employed, an experiment of crystallization can be simultaneously performed under a larger number of conditions (a plurality of types of mother liquors having different concentrations of contained protein and different pH values). For example, an apparatus shown in Fig. 52 can satisfy this requirement. This apparatus 210 has nine crystal growth cells 211 to 219, a single pH monitor cell 221 and two precipitant cells 231 and 232. The single pH monitor cell is sufficient for the plurality of crystal growth cells as in the apparatus 210 when crystallization is performed with a plurality of types of mother liquors having different protein concentrations, while the apparatus can have pH monitor cells in the same number as the crystal growth cells when a plurality of types of mother liquors having different pH values are employed. When the pH may not be monitored, all cells excluding the precipitant cells can be employed as crystal growth cells. A plurality of islands having different widths may be provided on each cell, or the width of the island may vary with the cell.

Example 2

An apparatus similar to that in Example 1 was prepared except that porous alumina was employed. In the apparatus 130 shown in Figs. 44 and 45, a plurality of islands 136 of porous alumina are formed in the crystal growth cells 132a and 132b and the pH monitor cell 134 on the silicon oxide film 135. The remaining structure is similar to that in Example 1.

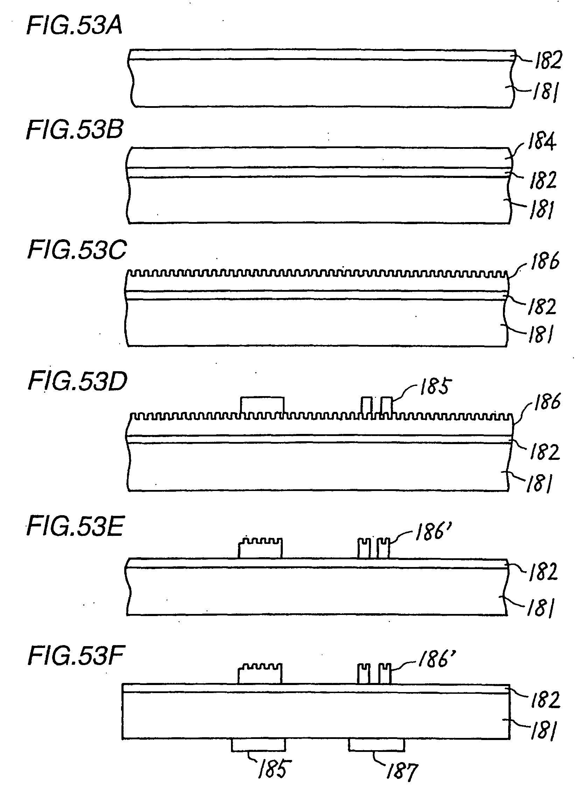

A number of bases of apparatuses can be simultaneously formed on a silicon wafer through a general fabrication process for a semiconductor device. For example, a silicon oxide film 182 of about 200 nm in thickness is first formed on the surface of a silicon wafer 181 by thermal oxidation, as shown in Fig. 53A. Then, an aluminum film 184 of about 3 to 5 μm in thickness is formed on the silicon oxide film 182 by sputtering or vapor deposition, as shown in Fig. 53B. Thereafter the aluminum film 184 is oxidized by anodization, for forming an alumina layer 186 as shown in Fig. 53C. The alumina layer 186 obtained at this time has a porous surface provided with fine irregularity. Then, a resist pattern 185 is formed on the alumina layer 186 through general photolithography, as shown in Fig. 53D. The alumina layer is removed by etching through a mask of generally employed resist while leaving only island parts. Thus, islands 186' of porous alumina are formed on the silicon oxide film 182, as shown in Fig. 53E. Thereafter the silicon wafer is cut (scribed) an electrode 185 and a heating element 187 are provided at need on the obtained chip, for obtaining a number of bases (Fig. 53F).

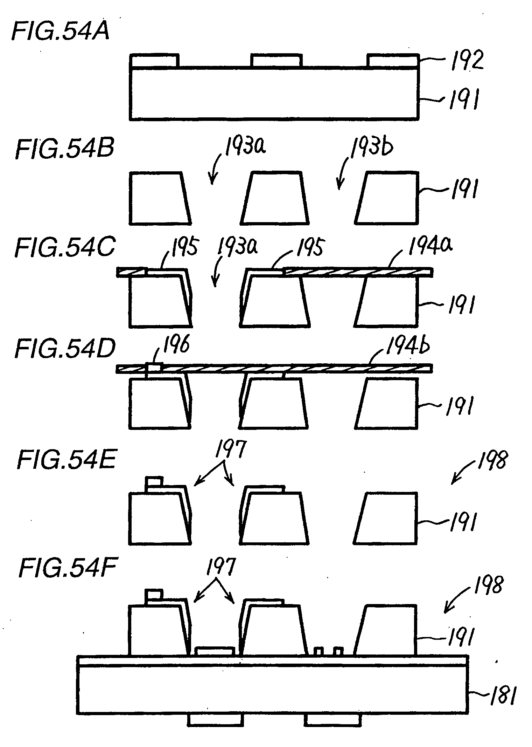

The solution holding plate is also prepared by general etching and sputtering as shown in Figs. 54A to 54F, for example. First, a resist mask 192 is formed on the surface of a Pyrex glass plate 191 in a prescribed pattern. Then, through holes 193a and 193b are formed in the glass plate 191 by wet etching with hydrofluoric acid or diamond blasting (Fig. 54B). Then, the portion excluding the through hole 193a for defining the pH monitor cell is covered with a hard mask 194a of an stainless-steel plate, for forming a Ti/Pt film 195 by sputtering (Fig. 54C). Thereafter a necessary portion is covered with a hard mask 194b, for forming an Au terminal 196 for connection by sputtering (Fig. 54D). Thus, a solution holding plate 198 having electrode parts 197 as shown in Fig. 54E is obtained. The obtained plate is connected to the base obtained through the process shown in Figs. 53A to 53F, for obtaining the apparatus (Fig. 54F).

Also in this Example, a crystal of protein is prepared through a process similar to that of Example 1. First, a solution (mother liquor) dissolving target protein is dropped on the crystal growth cell and the pH monitor cell by about 10 μl, for example. The concentration of protein in the solution is about 10 to 50 mg/ml. The optimum concentration varies with the type of the target protein. In order to crystallize unknown protein, a plurality of types of solutions having different concentrations may be prepared so that a plurality of apparatuses are prepared therefor for simultaneously performing crystal growth. At this time, the pH of each solution is adjusted to be higher than the isoelectric points of protein and a silicon oxide and lower than the isoelectric point of alumina. The pH of the solution is adjusted by adding a buffer solution. The isoelectric point of the silicon oxide is about 2, and that of alumina is about 9. When the isoelectric point of protein is about 7, therefore, the pH of the solution is adjusted to about 8. Thus, protein and the silicon oxide film exhibit negative surface potentials, while porous alumina exhibits a positive surface potential. The optimum pH of the solution also varies with the target protein. Therefore, a plurality of types of solutions having different pH values are preferably prepared for simultaneously performing crystallization with respect to these. A precipitant is introduced into the precipitant cell. More specifically, a mixture of 2 ml of an NaCl solution of 1 M and 2 ml of a standard buffer solution having pH of 4.6 is prepared and dropped into the precipitant cell by about 20 μl.

As shown in Fig. 51, the cells of the apparatus 130 are sealed with the transparent glass lid 200, and the apparatus 130 is kept in a cool dark place for about 100 hours. Protein molecules are gathered and fixed to the alumina island part due to electrostatic attraction. A crystal nucleus of protein is formed on the island part, and crystal growth progresses. The state of the crystal growth is observed with a microscope from above the transparent lid. At this time, a C-V meter 201 is connected to electrodes of the pH monitor cell for measuring C-V characteristics with an X-Y recorder 202, as shown in Fig. 51. Thus, the pH of the solution is monitored during crystal growth. The pH of the solution is changeable during crystal growth although the same is previously adjusted. Crystallinity of protein can be influenced by slight change of the pH of the solution. Therefore, it is important to grasp slight change of the pH in the actual process of crystal growth.


Example 3

The apparatus shown in Figs. 44 and 45 was first prepared. In the apparatus 130, the alumina islands 136 formed on the silicon oxide film 135 have a width of about 50 μm. The remaining structure is similar to that in Example 1. The apparatus is prepared through a process similar to that in Example 1. A crystal of protein is prepared by a method similar to that in Example 1. First, a solution (mother liquor) dissolving target protein is dropped on the crystal growth cell and the pH monitor cell by about 10 μl, for example. The concentration of protein in the solution is about 10 to 50 mg/ml. The optimum concentration varies with the type of target protein. In order to crystallize unknown protein, a plurality of types of solutions having different concentrations may be prepared so that a plurality of apparatuses are prepared therefor for simultaneously performing crystal growth. At this time, the pH of each solution is adjusted to be higher than the isoelectric points of protein and a silicon oxide and lower than the isoelectric point of alumina. The pH of the solution is adjusted by adding a buffer solution. The isoelectric point of the silicon oxide is about 2, and that of alumina is about 9. When the isoelectric point of the target protein is about 7, therefore, the pH of the solution is adjusted to about 8. Thus, protein and the silicon oxide film exhibit negative surface potentials, while alumina exhibits a positive surface potential. The optimum pH of the solution also varies with the target protein. Therefore, a plurality of types of solutions having different pH values are preferably prepared for simultaneously performing crystallization with respect to these. A precipitant is introduced into the precipitant cell.

As shown in Fig. 51, the cells of the apparatus 130 is sealed with the transparent glass lid 200, and the apparatus 130 is kept in a cool dark place for about 100 hours. Protein molecules are gathered and fixed to the alumina island part due to electrostatic attraction. A crystal nucleus of protein is formed on the island part, and crystal growth progresses. The state of the crystal growth is observed with a microscope from above the transparent lid. At this time, a C-V meter 201 is connected to electrodes of the pH monitor cell for measuring C-V characteristics with an X-Y recorder 202, as shown in Fig. 51. Thus, the pH of the solution is monitored during crystal growth. The pH of the solution is changeable during crystal growth although the same is previously adjusted. Crystallinity of protein can be influenced by slight change of the pH of the solution. Therefore, it is important to grasp slight change of the pH in the actual process of crystal growth.

Example 4

A suspension of catalase from bovine pancreas was dissolved in the same quantity of phosphate buffer solution having pH of 8.0. The obtained solution was dropped onto the surface of an apparatus employing a silicon crystal, for performing crystallization by a method similar to a sitting-drop method. Two types of crystal growth apparatuses were employed as follows:

(1) An alumina film of about 1 $\mu$m in thickness was formed on the surface of a P-type silicon substrate having specific resistance of about 20 $\Omega$·cm. Thereafter selective etching was performed as shown in Figs. 23A to 23D, for forming alumina islands. The width of the islands obtained by etching was about 50 $\mu$m. The silicon substrate formed with the islands was cut into 15 mm by 15 mm in size, for obtaining a crystal growth apparatus.
(2) A crystal growth apparatus was obtained similarly to the method (1), except that the width of alumina islands obtained by etching was set to about 1 mm.

In the apparatuses (1) and (2), 30 $\mu$l of the solution containing catalase was dropped to cover the surfaces of the silicon substrates and the surfaces of the islands, and the apparatuses were kept in a cool dark place of 5°C. After kept in the cool dark place for a week, the apparatuses were observed with a microscope. It was confirmed that crystals of catalase were precipitated on the surfaces of the islands of both apparatuses. The mean diameter of the observed crystals was about 0.1 mm.

The crystals growing on the surfaces of the islands in the respective apparatuses were sucked into pipettes along with the solution, which in turn was transferred from the pipettes to glass capillaries of about 1 mm in diameter to be sealed. In the apparatus (1), it was possible to readily suck the crystal into the pipette and seal the crystal in the capillary. In the apparatus (2), on the other hand, it was not much easy to suck the crystal into the pipette but the crystal may have been broken when the same was to be forcibly sucked into the pipette.

Example 5

Crystallization was performed with the apparatus shown in Figs. 25A and 25B. In the apparatus, the first substrate was a Pyrex glass plate of about 1 mm in thickness and about 5 cm by about 3 cm in size formed with 25 through holes of about 4 mm in diameter. Five second substrates were formed by the following substrates (A) to (E), having the structures shown in Figs. 28A to 28E respectively. The first substrate and the five second substrates were anode-bonded to each other.

(A) A substrate prepared by forming an n$^+$ doped layer on a p-type silicon surface having specific resistance of about 100 $\Omega$cm in a depth of about 5 $\mu$m.
(B) A substrate prepared by forming a p$^+$ doped layer on an n-type silicon surface having specific resistance of about 10 $\Omega$cm in a depth of about 5 $\mu$m.
(C) A substrate prepared by forming an n$^+$ doped layer on a p-type silicon surface having specific resistance of about 100 $\Omega$cm in a depth of about 5 $\mu$m and further forming an $SiO_2$ layer of about 100 nm in thickness thereon.
(D) A substrate prepared by forming an $SiO_2$ layer of about 100 nm in thickness on a p-type silicon surface having specific resistance of about 100 $\Omega$cm in a depth of about 100 nm and further forming an $Si_3N_4$ layer of about 100 nm in thickness thereon.
(E) A substrate prepared by forming an $SiO_2$ layer of about 100 nm in thickness on a p-type silicon surface having specific resistance of about 100 $\Omega$cm in a depth of about 100 nm and further forming an alumina layer of about 10 $\mu$m in thickness thereon by anodization.

In the substrates (A) to (E), the depth of concave portions formed by etching was about 100 $\mu$m, the area of the silicon surfaces coming into contact with a protein solution was about 15 mm$^2$, and the area of the upper surfaces of convex portions was about 0.3 mm$^2$. As shown in 28A to 28E, each substrate is provided with five crystallization regions.

Catalase from bovine liver was employed as protein to be crystallized. Three types of buffer solutions were prepared as follows:

(1) pH 5.2: 0.1 M citric acid-0.1 M $Na_2HPO_4$
(2) pH 8.0: 0.1 M $Na_2HPO_4$ -0.1 M $KH_2PO_4$
(1) pH 11.0: 0.05 M boric acid-0.05 M KCl-0.05 M $Na_2CO_3$

A catalase solution of 30 mg/ml in concentration was prepared with these buffer solutions, and the obtained solution was dropped into each well of the apparatuses by 10 μl. Further, NaCl was added to each well, and the concentration thereof was set to 0.1 M. The apparatuses were coated with covers, each well was sealed along with a precipitant containing 0.5 M of NaCl, and the apparatuses were left at a temperature of 4°C for 10 days. Consequently, it was confirmed that a crystal of about 0.5 mm in size was precipitated on the surface of the substrate (E) only in the sample of pH 8.0.

Industrial Availability

According to the present invention, organic molecules can be selectively adsorbed onto a specific solid surface, thereby reducing influence of convection on the organic molecules and stabling formation of a crystal nucleus of the organic molecules. According to the present invention, further, the crystal selectively grown on the specific solid surface can be readily taken out. According to the present invention, in addition, mass formation of microcrystals can be suppressed or controlled, so that a large-sized crystal enabling X-ray crystallographic analysis can be obtained. According to the present invention, further, it is possible to cope with crystallization of all types of organic molecules by employing a number of solid surfaces for crystallization. In the present invention, crystallization can be performed as to an extremely small amount of sample. According to the present invention, further, a larger number of conditions for crystallization can be formed in an apparatus having a simple structure.

The present invention can be employed for purifying or crystallizing various high molecular compounds, particularly high polymer electrolytes in pharmaceutical industry or food industry. The present invention is particularly preferably applied for purifying or crystallizing enzyme and protein such as membrane protein, polypeptide, peptide, polysaccharide and nucleic acid as well as complexes and derivatives thereof. In particular, the present invention is preferably applied for pulification or' crystallization of a biopolymer.

The apparatus according to the present invention can adsorb and fix a bio-related substance or the like charged in a solution to a specific region. Therefore, the present invention is applicable to a biosensor or a measuring apparatus for various types of vital tissues and biological substances with a biosensor.

**Claims**

1. An apparatus for separating a charged substance contained in a solution from said solution,
   comprising a plurality of types of solids consisting of materials substantially different from each other selected from a group consisting of a metal, a semiconductor and a compound thereof, wherein
   the surfaces of said plurality of types of solids are arranged to simultaneously come into contact with said solution, and
   the surfaces of said plurality of types of solids have surface potentials or zeta potentials different from each other when coming into contact with said solution,
   thereby more strongly electrostatically adsorbing said substance to the surface of any of said plurality of types of solids.

2. The apparatus according to claim 1, wherein at least one of said plurality of types of solids has a porous surface.

3. The apparatus according to claim 2, wherein the surface of said solid having said porous surface has a surface potential or a zeta potential different from those of the surfaces of remaining said solids, for more strongly electrostatically adsorbing said substance to said porous surface.

4. The apparatus according to claim 2 or 3, wherein said porous surface mainly has pores having a pore diameter substantially equivalent to or not more than the size of said substance.

5. The apparatus according to any of claims 2 to 4, wherein the material for said solid having said porous surface is alumina.

6. The apparatus according to any of claims 1 to 5, further comprising an enclosure wall for holding said solution on the surfaces of said plurality of types of solids.

7. The apparatus according to any of claims 1 to 6, wherein said plurality of types of solids are arranged to be adjacent to each other in a prescribed region, and
   the area occupied by the surface of said solid more strongly electrostatically adsorbing said substance is not more than the area occupied by the surfaces of remaining said solids in said prescribed region.

8. The apparatus according to any of claims 1 to 7, wherein said plurality of types of solids are formed on the same substrate.

9. The apparatus according to claim 8, wherein said substrate is a semiconductor substrate.

10. The apparatus according to any of claims 1 to 9, wherein the materials providing said plurality of types of solids have a multilayer structure, and
   the upper layer material is provided on a plurality of positions of the lower layer material at intervals in said multilayer structure.

11. An apparatus for separating a charged substance contained in a solution from said solution, wherein
   said apparatus has a surface for coming into contact with said solution,
   said surface has a plurality of regions,
   the respective ones of said plurality of regions are surfaces exposing materials substantially different from each other selected from a group consisting of a metal, a semiconductor and a compound thereof, and
   said plurality of regions are charged to surface potentials different from each other when coming into contact with said solution,
   for more strongly electrostatically adsorbing said charged substance to any of said plurality of regions.

12. An apparatus for separating a charged substance contained in a solution from said solution, comprising:

   a first solid; and
   a second solid, wherein
   said first solid is a semiconductor substrate,
   said second solid is an island made of a semiconductor compound or an island made of a metal compound formed on said first solid, and
   the surface of said first solid and the surface of said second solid are charged to surface potentials or zeta potentials different from each other when coming into contact with said solution, thereby more strongly electrostatically adsorbing said charged substance to the surface of said second solid.

13. The apparatus according to claim 12, wherein said semiconductor substrate is a silicon substrate.

14. The apparatus according to claim 12 or 13, wherein the material for at least the top portion of said island is any of a silicon oxide, a silicon nitride, a metal oxide and a metal nitride.

15. The apparatus according to any of claims 12 to 14, wherein the width of the top portion of said island is 10 $\mu$m to 200 $\mu$m.

16. The apparatus according to any of claims 12 to 15, having an enclosure wall for holding said solution, provided on the surface of said first solid to enclose said island.

17. The apparatus according to claim 16, wherein said first solid and said second solid are arranged to be adjacent to each other in a region enclosed with said enclosure wall, and
   the area of the surface of the top portion of said second solid is smaller than the area of the surface of said first solid in said region.

18. The apparatus according to any of claims 12 to 17, wherein said second solid is a plurality of islands having different widths of top portions.

19. The apparatus according to any of claims 12 to 18, wherein the combination of the material for the surface part of said first solid and the material for the surface part of said second solid is a combination of any of silicon and a silicon oxide, silicon and a silicon nitride, and silicon and alumina.

20. An apparatus for separating a charged substance contained in a solution from said solution, comprising:

   a semiconductor substrate;
   a first solid; and
   a second solid; wherein

said first solid is a semiconductor compound film or a metal compound film formed on said semiconductor substrate,

said second solid is an island made of a semiconductor compound or an island made of a metal compound formed on said first solid, and

the surface of said first solid and the surface of said second solid are charged to surface potentials or zeta potentials different from each other when coming into contact with said solution, thereby more strongly electrostatically adsorbing said charged substance to the surface of said second solid.

21. The apparatus according to claim 20, wherein said semiconductor substrate is a silicon substrate.

22. The apparatus according to claim 20 or 21, wherein the material for at least the top portion of said island is any of a silicon oxide, a silicon nitride, a metal oxide and a metal nitride.

23. The apparatus according to any of claims 20 to 22, wherein the width of the top portion of said island is 10 $\mu$m to 200 $\mu$m.

24. The apparatus according to any of claims 20 to 23, having an enclosure wall for holding said solution, provided on the surface of said first solid to enclose said island.

25. The apparatus according to claim 24, wherein said first solid and said second solid are arranged to be adjacent to each other in a region enclosed with said enclosure wall, and

the area of the surface of the top portion of said second solid is smaller than the area of the surface of said first solid in said region.

26. The apparatus according to any of claims 20 to 25, wherein said second solid is a plurality of islands having different widths of top portions.

27. The apparatus according to any of claims 20 to 26, wherein the combination of the material for the surface part of said first solid and the material for the surface part of said second solid is a combination of any of a silicon oxide and a silicon nitride, a silicon oxide and alumina, and a silicon nitride and alumina.

28. An apparatus for separating a charged substance contained in a solution from said solution, comprising:

a first member having a plurality of through holes provided at spaces from each other; and
a second member combined with said first member to block said plurality of through holes, wherein
a surface of said second member exposed in said through holes includes a first region and a second region, and
said first region and said second region are charged to surface potentials or zeta potentials different from each other when said surface comes into contact with said solution, thereby more strongly electrostatically adsorbing said charged substance to said second region.

29. The apparatus according to claim 28, wherein said first region is a surface exposing a first material selected from a group consisting of a metal, a semiconductor and a compound thereof, and said second region is a surface exposing a material selected from a group consisting of a metal, a semiconductor and a compound thereof substantially different from said first material.

30. The apparatus according to claim 29, wherein said first material is a material selected from a group consisting of silicon, a silicon oxide film and a silicon nitride film, and

said second material is a material selected from a group consisting of silicon, a silicon nitride and a metal oxide film.

31. The apparatus according to claim 28, wherein said second member is provided in plural, and single said first member and a plurality of said second members are combined with each other.

32. The apparatus according to claim 31, wherein said first region is a surface exposing a first material selected from a group consisting of a metal, a semiconductor and a compound thereof, and said second region is a surface exposing a material substantially different from said first material.

33. The apparatus according to claim 32, wherein combinations of said first material and said second material are different from each other between said plurality of second members.

34. The apparatus according to any of claims 28 to 33, wherein said second region is smaller than said first region.

35. The apparatus according to any of claims 1 to 34, further comprising means for measuring the pH of said solution containing said substance.

36. The apparatus according to claim 35, wherein said pH measuring means includes:

> a semiconductor layer,
> an insulating layer formed on said semiconductor layer,
> an enclosure wall for holding said solution on said insulating layer, and
> a metal electrode provided on said enclosure wall to come into contact with said solution.

37. The apparatus according to any of claims 1 to 36, wherein said charged substance is an organic molecule.

38. The apparatus according to claim 37, wherein said organic molecule is a biopolymer.

39. The apparatus according to claim 38, wherein said biopolymer is protein.

40. The apparatus according to claim 37, for preparing a crystal of said organic molecule.

41. A method of separating a charged organic molecule contained in a solution from said solution, comprising:

> a step of bringing said solution containing said organic molecule and having pH other than the isoelectric point of said organic molecule into contact with the surfaces of said plurality of types of solids of the apparatus according to any of claims 1 to 36.

42. A method of preparing a crystal of a charged organic molecule contained in a solution from said solution, comprising steps of:

> bringing said solution containing said organic molecule and having pH other than the isoelectric point of said organic molecule into contact with the surfaces of said plurality of types of solids of the apparatus according to any of claims 1 to 36; and
> maintaining said contact so that said crystal of said organic molecule grows on any of the surfaces of said plurality of types of solids.

43. A method of preparing a crystal of a charged organic molecule contained in a solution, comprising steps of:

> bringing said solution containing said organic molecule and having pH other than the isoelectric point of said organic molecule into contact with the surfaces of said plurality of types of solids of the apparatus according to any of claims 1 to 36; and
> sealing said apparatus along with a precipitant and maintaining said contact so that said crystal of said organic molecule grows on any of the surfaces of said plurality of types of solids.

44. The method according to any of claims 41 to 43, wherein the pH of said solution containing said organic molecule brings a surface potential or a zeta potential of a reverse polarity to said organic molecule to at least one of the surfaces of said plurality of types of solids while bringing a surface potential or a zeta potential of the same polarity as said organic molecule to the surfaces of remaining said solids.

45. A kit for the apparatus according to any of claims 28 to 34, comprising:

> a first member having a plurality of through holes provided at spaces from each other, and
> a plurality of second members having a plurality of types of surfaces exhibiting surface potentials or zeta potentials different from each other in said solution respectively.

46. An apparatus for preparing a crystal of protein contained in a solution, comprising:

a substrate; and

an island, formed on a prescribed region of said substrate, consisting of a material substantially different from said substrate at least on a top portion, wherein

the surface of said substrate and the surface of said island are charged to surface potentials different from each other when said island and the surface of said substrate present around said island are simultaneously brought into contact with said solution, thereby adsorbing a protein molecule contained in said solution onto said island and growing said crystal of protein on said island.

47. The apparatus according to claim 46, further having an enclosure wall provided on said substrate to enclose said island and the surface of said substrate present around said island.

48. The apparatus according to claim 47, wherein the area occupied by the surface of the top portion of said island present on a portion enclosed with said enclosure wall is smaller than the area occupied by the surface of said substrate other than said island present on said portion.

49. The apparatus according to any of claims 46 to 48, wherein the top portion of said island has a width allowing said crystal of protein to grow beyond the top portion of said island.

50. The apparatus according to any of claims 46 to 49, wherein the width of the top portion of said island is 10 μm to 200 μm.

51. An apparatus for preparing a crystal of protein contained in a solution, comprising:

a substrate;

a film formed on said substrate; and

an island, formed on said film, consisting of a material substantially different from said film at least on a top portion, wherein

the surface of said film and the surface of said island are charged to surface potentials different from each other when said island and the surface of said film present around said island are simultaneously brought into contact with said solution, thereby adsorbing a protein molecule contained in said solution onto said island and growing said crystal of protein on said island.

52. The apparatus according to claim 51, further comprising an enclosure wall provided on said substrate to enclose said island and the surface of said film present around said island.

53. The apparatus according to claim 52, wherein the area occupied by the surface of the top portion of said island present on a portion enclosed with said enclosure wall is smaller than the area occupied by the surface of said substrate other than said island present on said portion.

54. The apparatus according to any of claims 51 to 53, wherein the top portion of said island has a width allowing said crystal of protein to grow beyond the top portion of said island.

55. The apparatus according to claims 51 to 54, wherein the width of the top portion of said island is 10 μm to 200 μm.

56. A crystal preparation apparatus for preparing a crystal of an organic molecule contained in a solution, comprising:

(1) a first member having a plurality of through holes provided at spaces from each other, and
(2) a plurality of second members bonded to said first member, wherein

said second members include:

(a) substrates, and
(b) islands, formed on the surfaces of said substrates, consisting of a material different from said substrates at least on top portions, and

said islands are formed to be present inside said through holes.

57. The crystal preparation apparatus according to claim 56, wherein said substrates consist of silicon, and the material for at least the top portions of said islands consists of a metal oxide or a silicon nitride.

**58.** A crystal preparation apparatus for preparing a crystal of an organic molecule contained in a solution, comprising:

(1) a first member having a plurality of through holes provided at spaces from each other; and
(2) a plurality of second members bonded to said first member, wherein

said second members include:

(a) substrates,
(b) films, formed on the surfaces of said substrates, consisting of a material different from said substrates, and
(c) islands, formed on said films, consisting of a material different from said films at least on top portions, and

said islands are formed to be present inside said through holes.

**59.** The crystal preparation apparatus according to claim 58, wherein said substrates consist of silicon, and the material for at least the top portions of said islands consists of a metal oxide or a silicon nitride.

# FIG. 1A

# FIG. 1B

*FIG.2A*

*FIG.2B*

FIG.3

*FIG.4*

FIG.5A

FIG.5B

*FIG.6A*

MOLECULAR SIZE

*FIG.6B*

MOLECULAR SIZE

FIG.7

FIG.8

*FIG.9*

*FIG.10*

F I G. 1 1

*FIG.12A*

41a

42a

*FIG.12B*

41b

42b

*FIG.12C*

41c

42c

*FIG.13A*

*FIG.13B*

*FIG.14*

*FIG.15*

FIG.16A

*32a*

d

FIG.16B

*32b*

d

FIG.16C

d

*32c*

FIG.16D

d

*32d*

FIG.17A

FIG.17B

FIG.18A

FIG.18B

*FIG.19A*

82
81

*FIG.19B*

94
82
81

*FIG.19C*

95
94
82
81

*FIG.19D*

84
82
81

*FIG.20A*

80

85

86

84a

84b

84

82

81

*FIG.20B*

84

81

86

*FIG.21A*

82
81

*FIG.21B*

94
82
81

*FIG.21C*

95
94'
82
81

*FIG.21D*

84
94'
82
81

FIG.22A

FIG.22B

*FIG.23A*

81

*FIG.23B*

94

81

*FIG.23C*

95

94

81

*FIG.23D*

84a

84

81

FIG.24A

— 82

— 81

FIG.24B

— 94
— 82

— 81

FIG.24C

— 95

— 94
— 82

— 81

FIG.24D

94 — ← 96

— 82

— 81

F I G. 2 5 A

70

71

72

72

73

73

X

X

F I G. 2 5 B

73  74  75

75  74  70  73

71

72

72

76

76

## FIG. 26A

## FIG. 26B

## FIG. 27

FIG. 28A

282
281

FIG. 28B

284
283

FIG. 28C

285
282
281

FIG. 28D

286
285
281

FIG. 28E

287
285
281

FIG. 29A

FIG. 29B

FIG. 29C

FIG. 30A

FIG. 30B

FIG. 30C

FIG. 30D

FIG. 30E

*FIG.31A*

*FIG.31B*

F I G. 3 2 A

130

132a
132b
132c
132d

F I G. 3 2 B

132a    132b

F I G. 3 3 A

140

142a
142b

141

F I G. 3 3 B

142a    142b

FIG. 34A

FIG. 34B

FIG. 35

FIG. 36

F I G. 3 7 A

F I G. 3 7 B

FIG. 38

274   278          278      278      383

370
271
272
380

386      381      386      381      386

FIG. 39

274   278   384   278   384   278   385

370
271
272
380

382 386   381   386   381   386

FIG.40

FIG.41

C/Cox

CAPACITY

SOLUTION ②

$\Delta V_{FB}$

SOLUTION ①

−     0     +    BIAS
VOLTAGE

FIG.42

$V_{FB}$

SOLUTION ①     SOLUTION ②     pH

FIG.43

FIG.44

EP 1 223 235 A1

FIG.45

FIG.46

144 144b 144a 144a 144b 144

136

FIG.47A

136

FIG.47B

136

FIG.48

FIG.49A

~182
~181

FIG.49B

184
182
181

FIG.49C

185
184
182
181

FIG.49D

184'
182
181

FIG.49E

184'
182
181

185     187

FIG.50A

FIG.50B

FIG.50C

FIG.50D

FIG.50E

FIG.50F

FIG.51

FIG.52

FIG.53A

182
181

FIG.53B

184
182
181

FIG.53C

186
182
181

FIG.53D

185
186
182
181

FIG.53E

186'
182
181

FIG.53F

186'
182
181

185   187

FIG.54A

192

191

FIG.54B

193a    193b

191

FIG.54C

195   193a   195   194a

191

FIG.54D

196   194b

191

FIG.54E

197   198

191

FIG.54F

197   198

191

181

## INTERNATIONAL SEARCH REPORT

| International application No. |
| --- |
| PCT/JP00/03820 |

**A. CLASSIFICATION OF SUBJECT MATTER**
Int.Cl$^7$   C30B29/54

According to International Patent Classification (IPC) or to both national classification and IPC

**B. FIELDS SEARCHED**

Minimum documentation searched (classification system followed by classification symbols)
Int.Cl$^7$   C30B1/00-35/00, B01D9/02

Documentation searched other than minimum documentation to the extent that such documents are included in the fields searched
Jitsuyo Shinan Koho        1926-1996    Toroku Jitsuyo Shinan Koho  1994-2000
Kokai Jitsuyo Shinan Koho  1971-2000    Jitsuyo Shinan Toroku Koho  1996-2000

Electronic data base consulted during the international search (name of data base and, where practicable, search terms used)
CAS ONLINE
JICST FILE

**C. DOCUMENTS CONSIDERED TO BE RELEVANT**

| Category* | Citation of document, with indication, where appropriate, of the relevant passages | Relevant to claim No. |
| --- | --- | --- |
| A | A. Sanjoh et al., "Spatiotemporal protein crystal growth studies using microfluidic silicon devices", Journal of Crystal Growth, Vol. 196 (Jan. 1999), pp. 691-702 especially, page 696, left column, line 13 to page 697, right column, line 31; Fig.3 | 1-59 |
| A | WO, 99/23284, A1 (Sumitomo Metal Industries, Ltd.), 14 May, 1999 (14.05.99) & JP, 11-130600, A | 1-59 |

☐ Further documents are listed in the continuation of Box C.     ☐ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 04 September, 2000 (04.09.00) | 12 September, 2000 (12.09.00) |

| Name and mailing address of the ISA/ | Authorized officer |
| --- | --- |
| Japanese Patent Office | |
| Facsimile No. | Telephone No. |

Form PCT/ISA/210 (second sheet) (July 1992)